# EUROPEAN PATENT APPLICATION

(11) **EP 4 586 779 A1**
(43) Date of publication of application: **16.07.2025**
(21) Application number: 24199075.3
(22) Date of filing: 06.09.2024
(51) Int. Cl.: H10K 50/856, H10K 102/00

(54) **DISPLAY DEVICE AND METHOD OF MANUFACTURING DISPLAY DEVICE**

(30) Priority: 15.01.2024 KR 20240005886
(71) Applicant: Samsung Display Co., Ltd., Gyeonggi-do 17113 (KR)
(72) Inventor: YOU, Chun Gi, 17113 Yongin-si (KR)
(74) Representative: Marks & Clerk LLP

(57) **Abstract**

A display device and a method of manufacturing the display device are provided. The display device includes: a substrate arranged on a plane defined by a first direction and a second direction; a pixel circuit layer on the substrate and including a pixel circuit; a reflective layer on the pixel circuit layer; a barrier layer partially on the reflective layer; an anode electrode including a portion adjacent to the barrier layer and overlapping the reflective layer in a plan view; a light emitting structure electrically connected to the anode electrode; and a cathode electrode electrically connected to the light emitting structure, wherein the anode electrode includes a transparent conductive material including oxide, and is physically spaced apart from the reflective layer.

## Description

### BACKGROUND

### 1. Field

Aspects of some embodiments of the present disclosure relate to a display device and a method of manufacturing the display device.

### 2. Description of the Related Art

As consumer interest in an information display has recently increased, research and development on a display device is continuously being conducted.

An organic light emitting diode (OLED) generally has a relatively wide viewing angle and relatively excellent contrast, and may also be capable of being driven at a relatively low voltage, being lightweight and thin, and having a relatively fast response speed, as an active light emitting display element.

The display device may include a plurality of layers. Light emitted by the organic light emitting diode may pass through the plurality of layers and may be provided to the outside. When the light passes through the layers, a risk that an optical characteristic is changed may exist. For example, as the light passes through the layers, a luminance of the display device may decrease.

A manufacturing process of the display device may include a plurality of steps. The manufacturing process may be performed under various manufacturing environments, and a risk that at least a portion of the layers forming the display device is damaged according to the manufacturing environment may exist.

The above information disclosed in this Background section is only for enhancement of understanding of the background and therefore the information discussed in this Background section does not necessarily constitute prior art.

### SUMMARY

Aspects of some embodiments of the present disclosure include a display device with relatively improved optical characteristics (for example, a luminance) of the display device and relatively improved light output efficiency, and a method of manufacturing the display device.

Aspects of some embodiments of the present disclosure include a display device and a method of manufacturing the display device that may prevent or relatively reduce damage to a layer of the display device during a manufacturing process of the display device.

Aspects of some embodiments of the present disclosure include a display device and a method of manufacturing the display device in which reliability of an electrical signal for a light emitting element is improved.

According to some embodiments of the present disclosure, a display device includes a substrate on a plane based on a first direction and a second direction, a pixel circuit layer on the substrate and including a pixel circuit, a reflective layer on the pixel circuit layer, a barrier layer partially on the reflective layer, an anode electrode including a portion adjacent to the barrier layer and overlapping the reflective layer in a plan view, a light emitting structure electrically connected to the anode electrode, and a cathode electrode electrically connected to the light emitting structure. According to some embodiments, the anode electrode includes a transparent conductive material including oxide, and is physically spaced apart from the reflective layer.

According to some embodiments, the transparent conductive material may include at least one of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂).

According to some embodiments, the barrier layer may include titanium nitride (TiN).

According to some embodiments, the display device may further include a protective layer covering the reflective layer. According to some embodiments, a lower surface of the barrier layer may contact an upper surface of the reflective layer, and at least a portion of the barrier layer may be on the protective layer.

According to some embodiments, a lower surface of the barrier layer may entirely contact an upper surface of the reflective layer.

According to some embodiments, the display device may further include a protective layer covering the reflective layer. According to some embodiments, the barrier layer may include a first barrier layer and a second barrier layer on the first barrier layer. According to some embodiments, a lower surface of the first barrier layer may entirely contact an upper surface of the reflective layer. According to some embodiments, at least a portion of the second barrier layer may be on the protective layer.

According to some embodiments, the reflective layer may include a lower reflective layer, an interlayer lower reflective layer on the lower reflective layer, and an upper reflective layer on the interlayer lower reflective layer. According to some embodiments, the upper reflective layer may include a metal material and may be directly adjacent to the barrier layer.

According to some embodiments, the display device may further include a sub-pixel including a first sub-pixel providing light of a first color, a second sub-pixel providing light of a second color, and a third sub-pixel providing light of a third color. According to some embodiments, in the first sub-pixel, the reflective layer may further include a step forming layer on the lower reflective layer and covered by the interlayer lower reflective layer. According to some embodiments, the barrier layer may not overlap the step forming layer in a plan view.

According to some embodiments, the display device may further include a protective layer covering the reflective layer and including an opening exposing the reflective layer. According to some embodiments, the display device may further include a pixel defining layer covering the anode electrode and including a lower pixel defining layer and an upper pixel defining layer on the lower pixel defining layer. According to some embodiments, the lower pixel defining layer may expose the anode electrode in an anode exposure area. According to some embodiments, at least a portion of the lower pixel defining layer may be provided in the opening. According to some embodiments, the barrier layer may overlap the lower pixel defining layer and the upper pixel defining layer in a plan view.

According to some embodiments, the display device may further include a trench passing through the pixel defining layer and a portion of the protective layer. According to some embodiments, the substrate may include a silicon substrate.

According to some embodiments, the display device may further include a display area, and a dam structure in a dam area formed around the display area and including a dam insulating layer. According to some embodiments, the display device may further include a protective layer covering the reflective layer. According to some embodiments, in the dam area, the protective layer may include a dam opening. According to some embodiments, the dam insulating layer may include a first dam insulating layer, a second dam insulating layer on the first dam insulating layer, and a third dam insulating layer on the second dam insulating layer. According to some embodiments, at least a portion of the third dam insulating layer may be provided in the dam opening.

According to some embodiments, the display device may further include an alignment key on the pixel circuit layer and including a lower alignment key and an upper alignment key. According to some embodiments, at least a portion of the lower alignment key may include the same material as the reflective layer. According to some embodiments, at least a portion of the upper alignment key may include the same material as the anode electrode.

According to some embodiments of the present disclosure, a method of manufacturing a display device includes manufacturing a pixel circuit layer, forming a reflective layer on the pixel circuit layer, forming a barrier layer on the reflective layer, and patterning an anode electrode to be adjacent to the barrier layer. According to some embodiments, the anode electrode includes a transparent conductive material including oxide and is physically spaced apart from the reflective layer.

According to some embodiments, the transparent conductive material may include one or more of a group of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂). According to some embodiments, the barrier layer may include titanium nitride (TiN).

According to some embodiments, the method may further include forming a protective layer covering the reflective layer on the pixel circuit layer. According to some embodiments, patterning may include forming the anode electrode without exposing an upper surface of the reflective layer by the protective layer and the barrier layer.

According to some embodiments, forming the barrier layer may be performed after forming the protective layer.

According to some embodiments, forming the barrier layer may be performed before forming the protective layer.

According to some embodiments, forming the barrier layer may include forming a first barrier layer and forming a second barrier layer. According to some embodiments, forming the first barrier layer may be performed before forming the protective layer. According to some embodiments, forming the second barrier layer may be performed after forming the protective layer.

According to some embodiments, the method may further include patterning a pixel defining layer including a lower pixel defining layer covering the anode electrode and an upper pixel defining layer on the lower pixel defining layer. According to some embodiments, the protective layer may include an opening overlapping the reflective layer when viewed on a plane. According to some embodiments, at least a portion of the lower pixel defining layer may be provided in the opening.

According to some embodiments, the method may further include forming a light emitting structure electrically connected to the anode electrode, forming a cathode electrode electrically connected to the light emitting structure, and forming an encapsulation layer covering the cathode electrode.

At least some of the above and other features of the invention are set out in the claims.

According to some embodiments of the present disclosure, a display device with relatively improved optical characteristics (for example, a luminance) of the display device and relatively improved light output efficiency, and a method of manufacturing the display device may be provided.

According to some embodiments of the present disclosure, a display device and a method of manufacturing the display device may prevent or relatively reduce damage to a layer of the display device during a manufacturing process of the display device.

According to some embodiments of the present disclosure, a display device and a method of manufacturing the display device in which reliability of an electrical signal for a light emitting element is improved may be provided.

### BRIEF DESCRIPTION OF THE DRAWINGS

The above and other aspects of some embodiments of the present disclosure will become more apparent by describing in further detail aspects of some embodiments thereof with reference to the accompanying drawings, in which:
FIG. 1 is a schematic plan view illustrating a display device according to some embodiments;
FIG. 2 is a schematic exploded perspective view illustrating a display device according to some embodiments;
FIG. 3 is a plan view illustrating aspects of one of the pixels of FIG. 2 according to some embodiments;
FIG. 4 is a plan view illustrating aspects of one of the pixels of FIG. 2 according to some embodiments;
FIG. 5 is a plan view illustrating aspects of one of the pixels of FIG. 2 according to some embodiments;
FIG. 6 is a schematic cross-sectional view illustrating an arrangement relationship between a barrier layer and other layers adjacent thereto according to some embodiments;
FIGS. 7, 11, and 12 are schematic cross-sectional views illustrating a display device according to some embodiments;
FIG. 8 is a schematic cross-sectional view illustrating a portion of a display device in a dam area according to some embodiments;
FIGS. 9 and 10 are schematic cross-sectional views illustrating a light emitting structure according to some embodiments;
FIG. 13 is a schematic flowchart illustrating a method of manufacturing a display device according to some embodiments;
FIGS. 14 to 26 are schematic cross-sectional views for each process step illustrating a method of manufacturing a display device according to some embodiments;
FIG. 27 is a schematic flowchart illustrating a method of manufacturing a display device according to some embodiments;
FIGS. 28 to 30 are schematic cross-sectional views for each process step illustrating a method of manufacturing a display device according to some embodiments;
FIG. 31 is a schematic flowchart illustrating a method of manufacturing a display device according to some embodiments;
FIGS. 32 to 35 are schematic cross-sectional views for each process step illustrating a method of manufacturing a display device according to some embodiments;
FIG. 36 is a block diagram illustrating aspects of a display system according to some embodiments;
FIG. 37 is a perspective view illustrating an application example of the display system of FIG. 36 according to some embodiments; and
FIG. 38 is a diagram illustrating a head mounted display device of FIG. 37 worn by a user according to some embodiments.

### DETAILED DESCRIPTION

Hereinafter, aspects of some embodiments of the present disclosure are described in more detail with reference to the accompanying drawings. It should be noted that in the following description, only portions necessary for understanding an operation according to the disclosure are described, and descriptions of other portions are omitted in order not to obscure the subject matter of the disclosure. In addition, the disclosure may be embodied in other forms without being limited to the embodiments described herein. However, the embodiments described herein are provided to describe in detail enough to easily implement the technical idea of the disclosure to those skilled in the art to which the disclosure belongs.

Throughout the specification, in a case where a portion is "connected" to another portion, the case includes not only a case where the portion is "directly connected" but also a case where the portion is "indirectly connected" with another element interposed therebetween. Terms used herein are for describing specific embodiments and are not intended to limit the disclosure. Throughout the specification, in a case where a certain portion "includes" a component, the case means that the portion may further include another component without excluding another component unless otherwise stated. "At least any one of X, Y, and Z" and "at least any one selected from a group consisting of X, Y, and Z" may be interpreted as one X, one Y, one Z, or any combination of two or more of X, Y, and Z (for example, XYZ, XYY, YZ, and ZZ). Here, "and/or" includes all combinations of one or more of corresponding configurations.

Here, terms such as first and second may be used to describe various components, but these components are not limited to these terms. These terms are used to distinguish one component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions of the device in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in the present disclosure, the term "under" may include both directions of on and under. In addition, the device may face in other directions (for example, rotated 90 degrees or in other directions) and thus the spatially relative terms used herein are interpreted according thereto.

Various embodiments are described with reference to drawings schematically illustrating preferred embodiments. Accordingly, it will be expected that shapes may vary, for example, according to tolerances and/or manufacturing techniques. Therefore, the embodiments disclosed herein cannot be construed as being limited to shown specific shapes, and should be interpreted as including, for example, changes in shapes that occur as a result of manufacturing. As described above, the shapes shown in the drawings may not show actual shapes of areas of a device, and the present embodiments are not limited thereto.

Aspects of some embodiments of the present disclosure relate to a display device and a method of manufacturing the display device. Hereinafter, a display device and a method of manufacturing the display device according to some embodiments are described in more detail with reference to the attached drawings.

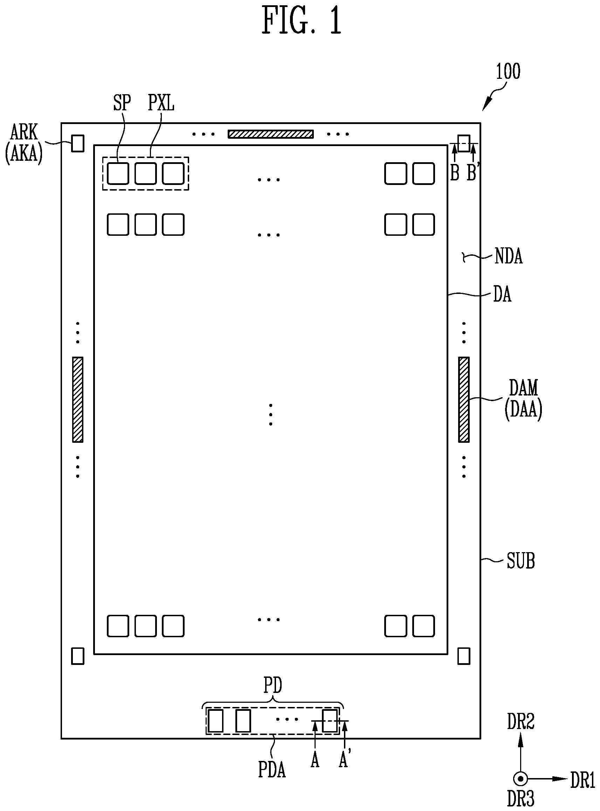

FIG. 1 is a schematic plan view illustrating a display device according to some embodiments.

Referring to FIG. 1, the display device 100 according to some embodiments is configured to emit light.

The display device 100 may include a display area DA and a non-display area NDA. The display device 100 displays an image through the display area DA. The non-display area NDA is arranged around (e.g., in a periphery or outside a footprint of) the display area DA in a plan view.

The display device 100 may include a substrate SUB, sub-pixels SP, and pads PD. According to some embodiments, the display device 100 may further include an alignment key ARK and a dam structure DAM.

When the display device 100 is used as a display screen of a head mounted display (HMD) device, a virtual reality (VR) device, a mixed reality (MR) device, an augmented reality (AR) device, or the like, the display device 100 may be positioned very close to user's eyes. In this case, sub-pixels SP of a relatively high integration degree may be desirable. In order to increase an integration degree of the sub-pixels SP, the substrate SUB may be provided as a silicon substrate. Layers for forming the sub-pixels SP and/or the display device 100 may be formed on the substrate SUB, which is the silicon substrate. The display device 100 including the substrate SUB, which is the silicon substrate, may be referred to as an OLED on silicon (OLEDoS) display device.

The sub-pixels SP are located in the display area DA on the substrate SUB. The sub-pixels SP may be arranged in a matrix shape along a first direction DR1 and a second direction DR2 crossing the first direction DR1. However, embodiments according to the present disclosure are not limited thereto. For example, the sub-pixels SP may be arranged in a zigzag shape along the first direction DR1 and the second direction DR2. For example, the sub-pixels SP may be arranged in a PENTILE^{™} shape. The first direction DR1 may be a row direction, and the second direction DR2 may be a column direction.

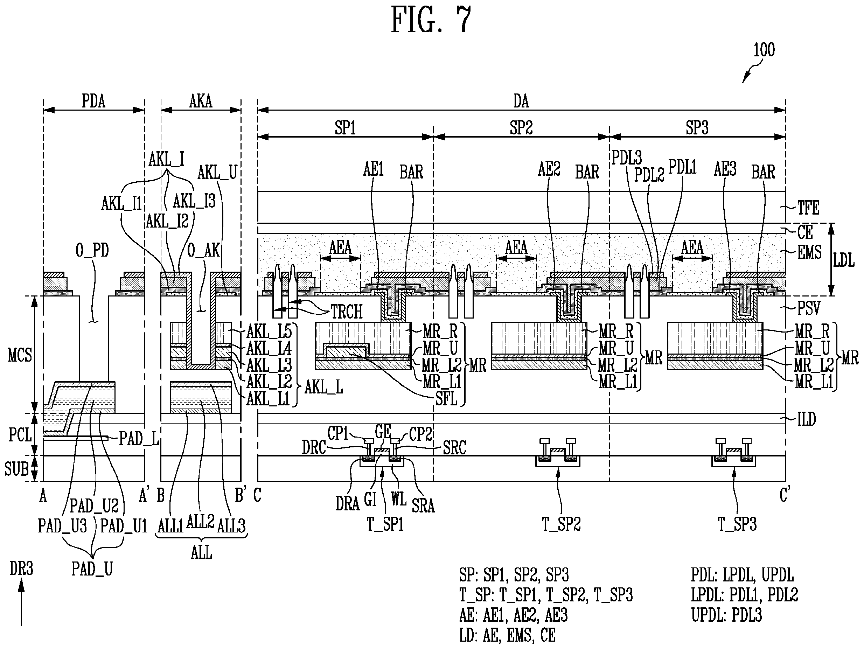

Each of the sub-pixels SP may include at least one light emitting element LD (refer to FIG. 7) configured to generate light. Accordingly, each of the sub-pixels SP may generate light of a specific color, such as red, green, blue, cyan, magenta, or yellow. Two or more sub-pixels SP among the sub-pixels SP may configure a pixel PXL. For example, as shown in FIG. 1, three sub-pixels SP may configure a pixel PXL.

Hereinafter, the disclosure is described based on embodiments in which the sub-pixels SP include a first sub-pixel SP1 providing light of a first color (for example, red), a second sub-pixel SP2 providing light of a second color (for example, green), and a third sub-pixel SP3 providing light of a third color (for example, blue).

According to some embodiments, the first sub-pixel SP1 may be a red pixel and may provide light of a wavelength band of 600 nm to 750 nm. The second sub-pixel SP2 may be a green pixel and may provide light of a wavelength band of 480 nm to 560 nm. The third sub-pixel SP3 may be a blue pixel and may provide light of a wavelength band of 370 nm to 460 nm.

A component for controlling the sub-pixels SP may be located in the non-display area NDA on the substrate SUB. For example, lines connected to the sub-pixels SP (for example, gate lines, data lines, and the like for driving the sub-pixels SP) may be located in the non-display area NDA. In addition, a gate driver, a data driver, a voltage generator, a controller, a temperature sensor, and the like for obtaining driving signals supplied to the sub-pixels SP may be integrated into the non-display area NDA of the display device. However, embodiments according to the present disclosure are not limited thereto.

Pads PD are located in a pad area PDA formed in the non-display area NDA on the substrate SUB. The pads PD may be electrically connected to the sub-pixels SP through lines. For example, the pads PD may be connected to the sub-pixels SP through data lines. According to some embodiments, the pads PD may include a lower pad layer PAD_L (refer to FIG. 7) and an upper pad layer PAD_U (refer to FIG. 7).

The pads PD may interface components in the display area DA and the non-display area NDA with other components of the display device 100. According to some embodiments, voltages and signals necessary for an operation of the components included in the display device 100 may be provided from a driver integrated circuit through the pads PD. For example, the data lines may be electrically connected to the driver integrated circuit through the pads PD. For example, power voltages for driving the sub-pixels SP may be received from the driver integrated circuit through the pads PD. For example, a gate control signal for controlling the gate driver may be transmitted from the driver integrated circuit to the gate driver through the pads PD.

According to some embodiments, a circuit board may be electrically connected to the pads PD using a conductive adhesive member such as an anisotropic conductive film. At this time, the circuit board may be a flexible circuit board (FPCB) or a flexible film having a flexible material. The driver integrated circuit may be mounted on the circuit board to be electrically connected to the pads PD.

According to some embodiments, the alignment key ARK may be located in an alignment key area AKA formed in the non-display area NDA. The alignment key ARK may include a plurality of alignment keys. According to some embodiments, the alignment keys ARK may be located at a corner portion of the display device 100. However, embodiments according to the present disclosure are not limited thereto.

The alignment key ARK may include a structure that may perform an alignment key function during a manufacturing process of the display device 100. For example, during the manufacturing process of the display device 100, a position of layers for manufacturing the display device 100 is required to be identified and determined. The alignment key ARK may be a structure that may be identified from other configurations in an adjacent area, and a positional relationship of each of the layers for manufacturing the display device 100 may be identified based on the position of the alignment key ARK.

According to some embodiments, the dam structure DAM may be located in a dam area DAA formed in the non-display area NDA. The dam structure DAM may surround at least a portion of the display area DA. The dam structure DAM may be located at a periphery of the display area DA. A position and the number of dam structures DAM are not limited to a specific example.

The dam structure DAM may protrude in a direction (for example, a third direction DR3), and thus a risk that materials provided during the manufacturing process of the display device DD are spread (or leaked) to an outside may be relatively reduced.

According to some embodiments, the display area DA may have various shapes. The display area DA may have a closed loop shape including straight and/or curved sides. For example, the display area DA may have shapes such as a polygon, a circle, a semicircle, and an ellipse.

According to some embodiments, the display device 100 may have a flat display surface. According to some embodiments, the display device 100 may have a display surface that is at least partially round. According to some embodiments, the display device 100 may be bendable, foldable, or rollable. In these cases, the display device 100 and/or the substrate SUB may include materials having a flexible property.

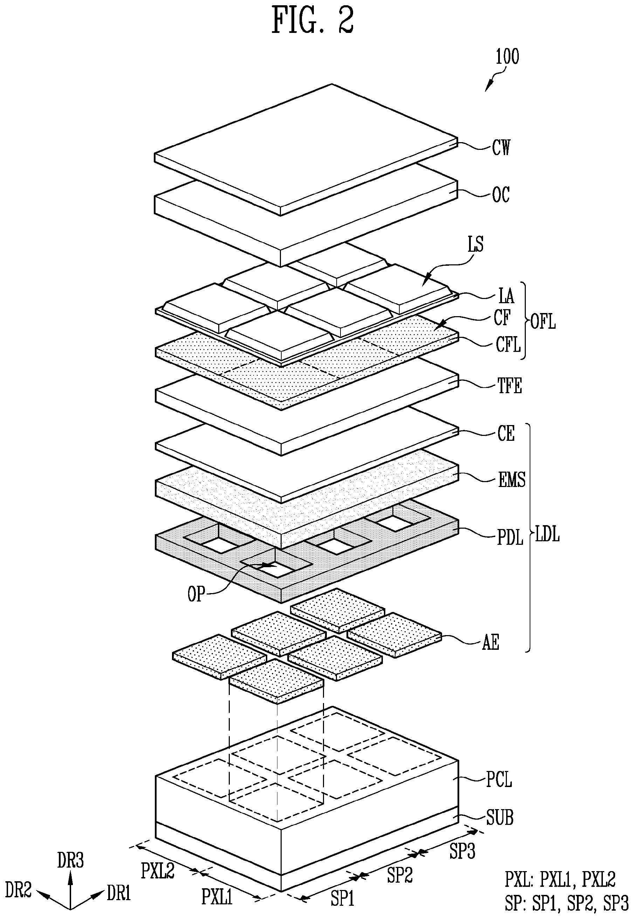

FIG. 2 is a schematic exploded perspective view illustrating a display device according to some embodiments. In FIG. 2, for clear and concise description, a portion of the display device 100 corresponding to two pixels PXL1 and PXL2 among the pixels PXL is schematically shown. A portion of the display device 100 corresponding to remaining pixels may be similarly configured.

Referring to FIG. 2, each of the first and second pixels PXL1 and PXL2 may include first to third sub-pixels SP1, SP2, and SP3. However, embodiments according to the present disclosure are not limited thereto. For example, each of the first and second pixels PXL1 and PXL2 may include four sub-pixels or two sub-pixels.

In FIG. 2, the first to third sub-pixels SP1, SP2, and SP3 have quadrangle shapes when viewed from a third direction DR3 crossing the first and second directions DR1 and DR2, and have sizes equal to each other. However, embodiments according to the present disclosure are not limited thereto. The first to third sub-pixels SP1, SP2, and SP3 may be modified to have various shapes.

The display device 100 may include the substrate SUB, a pixel circuit layer PCL, a light emitting element layer LDL, an encapsulation layer TFE, an optical functional layer OFL, an overcoat layer OC, and a cover window CW.

According to some embodiments, the display device 100 may further include an intermediate conductive structure layer MCS (refer to FIG. 7) located between the pixel circuit layer PCL and the light emitting element layer LDL. For convenience of description, the intermediate conductive structural layer MCS is not shown in FIG. 2, and the intermediate conductive structural layer MCS is described later with reference to the drawings FIG. 7 and after FIG. 7.

According to some embodiments, the substrate SUB may include a silicon wafer substrate formed using a semiconductor process. The substrate SUB may include a semiconductor material suitable for forming circuit elements. For example, the semiconductor material may include silicon, germanium, and/or silicon-germanium. The substrate SUB may be provided from a bulk wafer, an epitaxial layer, a silicon on insulator (SOI) layer, a semiconductor on insulator (SeOI) layer, or the like. According to some embodiments, the substrate SUB may include a glass substrate. According to some embodiments, the substrate SUB may include a polyimide (PI) substrate.

The pixel circuit layer PCL is located on the substrate SUB. The substrate SUB and/or the pixel circuit layer PCL may include insulating layers and conductive patterns located between the insulating layers. The conductive patterns of the pixel circuit layer PCL may function as at least a portion of circuit elements, lines, and the like. The conductive patterns may include copper, but embodiments according to the present disclosure are not limited thereto.

The circuit elements may include the sub-pixel circuit for each of the first to third sub-pixels SP1, SP2, and SP3. The sub-pixel circuit may include transistors and one or more capacitors. Each transistor may include a semiconductor portion including a source area, a drain area, and a channel area, and a gate electrode overlapping the semiconductor portion. According to some embodiments, when the substrate SUB is provided as a silicon substrate, the semiconductor portion may be included in the substrate SUB, and the gate electrode may be included in the pixel circuit layer PCL as a conductive pattern of the pixel circuit layer PCL. According to some embodiments, when the substrate SUB is provided as a glass substrate or a PI substrate, the semiconductor portion and the gate electrode may be included in the pixel circuit layer PCL. Each capacitor may include electrodes spaced apart from each other. For example, each capacitor may include electrodes spaced apart from each other on a plane defined by the first and second directions DR1 and DR2. For example, each capacitor may include electrodes spaced apart from each other in the third direction DR3 with an insulating layer interposed therebetween.

The lines of the pixel circuit layer PCL may include signal lines connected to each of the first to third sub-pixels SP1, SP2, and SP3, for example, a gate line, an emission control line, a data line, and the like. The lines may further include a line connected to a first power voltage node forming a first potential. In addition, the lines may further include a line connected to a second power voltage node forming a second potential lower than the first potential.

The light emitting element layer LDL may include anode electrodes AE, a pixel defining layer PDL, a light emitting structure EMS, and a cathode electrode CE.

The anode electrodes AE may be located on the pixel circuit layer PCL. The anode electrodes AE may be electrically connected to circuit elements of the pixel circuit layer PCL.

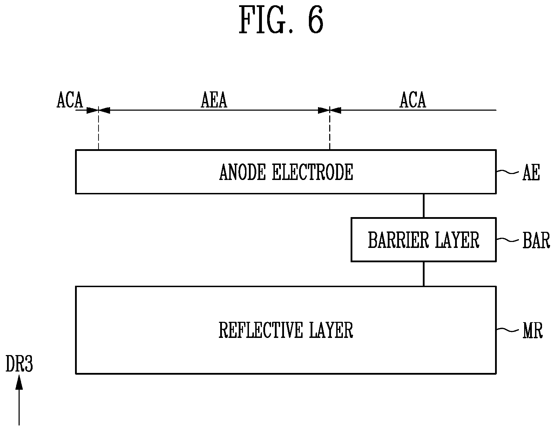

The pixel defining layer PDL is located on the anode electrodes AE. The pixel defining layer PDL may include an opening OP exposing a portion of each of the anode electrodes AE. The opening OP of the pixel defining layer PDL may be understood as emission areas corresponding to the first to third sub-pixels SP1 to SP3, respectively. According to some embodiments, an anode exposure area AEA (refer to FIG. 6) where the anode electrodes AE are exposed in the opening OP may be formed.

According to some embodiments, the pixel defining layer PDL may include an inorganic material. In this case, the pixel defining layer PDL may include a plurality of stacked inorganic layers. For example, the pixel defining layer PDL may include silicon oxide (SiOx) and silicon nitride (SiNx). According to some embodiments, the pixel defining layer PDL may include an organic material. However, a material of the pixel defining layer PDL is not limited thereto.

The light emitting structure EMS may be located on the anode electrodes AE exposed by the opening OP of the pixel defining layer PDL. The light emitting structure EMS may include a light emitting layer configured to generate light, an electron transport layer configured to transport an electron, a hole transport layer configured to transport a hole, and the like.

According to some embodiments, the light emitting structure EMS may fill the opening OP of the pixel defining layer PDL, and may be entirely arranged on the pixel defining layer PDL. In other words, the light emitting structure EMS may extend across the first to third sub-pixels SP1 to SP3. In this case, at least a portion of layers in the light emitting structure EMS may be disconnected or bent at boundaries between the first to third sub-pixels SP1 to SP3. However, embodiments according to the present disclosure are not limited thereto. For example, portions of the light emitting structure EMS corresponding to the first to third sub-pixels SP1 to SP3 may be separated from each other, and each of the portions may be located in the opening OP of the pixel defining layer PDL.

The cathode electrode CE may be located on the light emitting structure EMS. The cathode electrode CE may extend across the first to third sub-pixels SP1 to SP3. As described above, the cathode electrode CE may be provided as a common electrode for the first to third sub-pixels SP1 to SP3.

The cathode electrode CE may be a thin metal layer having a thickness sufficient to transmit light emitted from the light emitting structure EMS. The cathode electrode CE may be formed of a metal material or a transparent conductive material to have a relatively thin thickness. According to some embodiments, the cathode electrode CE may include at least one of various transparent conductive materials including indium tin oxide (ITO), indium zinc oxide (IZO), indium gallium zinc oxide (IGZO), antimony zinc oxide (AZO), indium tin zinc oxide (ITZO), zinc oxide (ZnO), or tin oxide (SnO₂). According to some embodiments, the cathode electrode CE may include at least one of silver (Ag), magnesium (Mg), and/or a mixture thereof. However, a material of the cathode electrode CE is not limited thereto.

It may be understood that the anode electrode AE, a portion of the light emitting structure EMS overlapping it, and a portion of the cathode electrode CE overlapping it configure a light emitting element LD. In other words, each of the light emitting elements LD of the first to third sub-pixels SP1 to SP3 may include an anode electrode AE, a portion of the light emitting structure EMS overlapping it, and a portion of the cathode electrode CE overlapping it. In each of the first to third sub-pixels SP1 to SP3, holes injected from the anode electrode AE and electrons injected from the cathode electrode CE may be transported into the light emitting layer of the light emitting structure EMS to form excitons, and when the excitons transits from an excited state to a ground state, light may be generated. A luminance of light may be determined according to an amount of a current flowing through the light emitting layer. According to a configuration of the light emitting layer, a wavelength range of the generated light may be determined.

The encapsulation layer TFE is located on the cathode electrode CE. The encapsulation layer TFE may cover the light emitting element layer LDL and/or the pixel circuit layer PCL. The encapsulation layer TFE may be configured to prevent or relatively reduce instances of contaminants such as oxygen, moisture, and/or the like permeating to the light emitting element layer LDL. According to some embodiments, the encapsulation layer TFE may include a structure in which one or more inorganic layers and one or more organic layers are alternately stacked. For example, the inorganic layer may include silicon nitride, silicon oxide, silicon oxynitride (SiOxNy), or the like. For example, the organic layer may include an organic insulating material such as acrylic resin, epoxy resin, phenol resin, polyamide resin, polyimide resin, unsaturated polyester resin, polyphenylenether resin, polyphenylenesulfide resin, or benzocyclobutene (BCB) resin. However, materials of the organic and the inorganic layers of the encapsulation layer TFE are not limited thereto.

In order to relatively improve an encapsulation efficiency of the encapsulation layer TFE, the encapsulation layer TFE may further include a thin film including aluminium oxide (AlOx). The thin film including the aluminium oxide may be positioned on an upper surface of the encapsulation layer TFE facing the optical functional layer OFL and/or a lower surface of the encapsulation layer TFE facing the light emitting element layer LDL.

The thin film including the aluminium oxide (AlOx) may be formed through atomic layer deposition (ALD) method. However, embodiments according to the present disclosure are not limited thereto. The encapsulation layer TFE may further include a thin film formed of at least one of various materials suitable for relatively improving the encapsulation efficiency.

The optical functional layer OFL is located on the encapsulation layer TFE. The optical functional layer OFL may include a color filter layer CFL and a lens array LA.

The color filter layer CFL is located between the encapsulation layer TFE and the lens array LA. The color filter layer CFL is configured to filter the light emitted from the light emitting structure EMS and selectively output light of a wavelength range or a color corresponding to each sub-pixel. The color filter layer CFL may include color filters CF respectively corresponding to the first to third sub-pixels SP1 to SP3, and each of the color filters CF may pass light of a wavelength range corresponding to the corresponding sub-pixel. For example, the color filter corresponding to the first sub-pixel SP1 may pass red color light, the color filter corresponding to the second sub-pixel SP2 may pass green color light, and the color filter corresponding to the third sub-pixel SP3 may pass blue color light. According to the light emitted from the light emitting structure EMS of each sub-pixel, at least a portion of the color filters CF may be omitted.

The lens array LA is located on the color filter layer CFL. The lens array LA may include lenses LS respectively corresponding to the first to third sub-pixels SP1 to SP3. Each of the lenses LS may relatively improve light output efficiency by outputting the light emitted from the light emitting structure EMS to an intended path. The lens array LA may have a relatively high refractive index. For example, the lens array LA may have a refractive index higher than that of the overcoat layer OC. According to some embodiments, the lenses LS may include an organic material. According to some embodiments, the lenses LS may include an acrylic material. However, a material of the lenses LS is not limited thereto.

According to some embodiments, compared to the opening OP of the pixel defining layer PDL, at least a portion of the color filters CF of the color filter layer CFL and at least a portion of the lenses LS of the lens array LA may be shifted in a direction parallel to the plane defined by the first and second directions DR1 and DR2. For example, in a central area of the display area DA, a center of the color filter CF and a center of the lens LS may be aligned with or overlap with a center of the opening OP of the corresponding pixel defining layer PDL when viewed in the third direction DR3 (e.g., in a plan view). For example, in the central area of the display area DA, the opening OP of the pixel defining layer PDL may completely overlap the corresponding color filter CF of the color filter layer CFL and the corresponding lens LS of the lens array LA. In an area adjacent to the non-display area NDA in the display area DA, the center of the color filter CF and the center of the lens LS may be shifted in a plane direction from the center of the opening OP of the corresponding pixel defining layer PDL when viewed in the third direction DR3 (e.g., in a plan view). For example, in the area adjacent to the non-display area NDA in the display area DA, the opening OP of the pixel defining layer PDL may be partially overlap of the corresponding color filter CF of the color filter layer CFL and the corresponding lens LS of the lens array LA. Accordingly, at a center of the display area DA, the light emitted from the light emitting structure EMS may be efficiently output in a normal direction of a display surface. At an outskirt of the display area DA, the light emitted from the light emitting structure EMS may be efficiently output in a direction inclined by an angle (e.g., a set or predetermined angle) with respect to the normal direction of the display surface.

The plane defined in the present specification may be a direction extending in the first direction DR1 and the second direction DR2 and may be defined based on a plane on which the substrate SUB is located. According to some embodiments, the third direction DR3 may be a thickness direction of the substrate SUB, and the third direction DR3 may be a light output direction of the display device 100.

The overcoat layer OC may be located on the lens array LA. The overcoat layer OC may cover the optical functional layer OFL, the encapsulation layer TFE, the light emitting structure EMS, and/or the pixel circuit layer PCL. The overcoat layer OC may include various materials suitable for protecting layers thereunder from a foreign substance such as dust or moisture. For example, the overcoat layer OC may include at least one of an inorganic insulating layer and an organic insulating layer. For example, the overcoat layer OC may include epoxy, but embodiments according to the present disclosure are not limited thereto. The overcoat layer OC may have a refractive index lower than that of the lens array LA.

The cover window CW may be located on the overcoat layer OC. The cover window CW is configured to protect layers thereunder. The cover window CW may have a refractive index higher than that of the overcoat layer OC. The cover window CW may include glass, but embodiments according to the present disclosure are not limited thereto. For example, the cover window CW may be an encapsulation glass configured to protect components located thereunder. According to some embodiments, the cover window CW may be omitted.

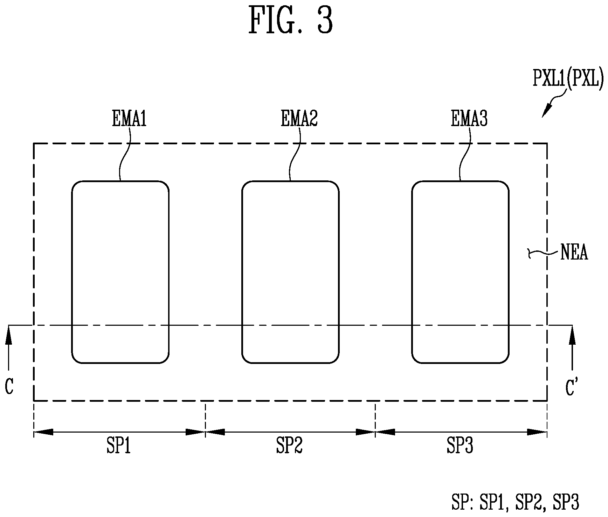

FIG. 3 is a plan view illustrating aspects of one of the pixels of FIG. 2 according to some embodiments. In FIG. 3, the first pixel PXL1 among the first pixel PXL1 and the second pixel PXL2 of FIG. 2 is schematically shown for clear and concise description. The remaining pixels may be configured similarly to the first pixel PXL1.

Referring to FIGS. 2 and 3, the first pixel PXL1 may include a first sub-pixel SP1, a second sub-pixel SP2, and a third sub-pixel SP3 arranged in the first direction DR1.

The first sub-pixel SP1 may include a first emission area EMA1 and a non-emission area NEA around the first emission area EMA1. The second sub-pixel SP2 may include a second emission area EMA2 and a non-emission area NEA around the second emission area EMA2. The third sub-pixel SP3 may include a third emission area EMA3 and a non-emission area NEA around the third emission area EMA3.

The first emission area EMA1 may be an area where light is emitted from a portion of the light emitting structure EMS corresponding to the first sub-pixel SP1 (for example, a first light emitting structure). The second emission area EMA2 may be an area where light is emitted from a portion of the light emitting structure EMS corresponding to the second sub-pixel SP2 (for example, a second light emitting structure). The third emission area EMA3 may be an area where light is emitted from a portion of the light emitting structure EMS corresponding to the third sub-pixel SP3 (for example, a third light emitting structure). As described with reference to FIG. 2, each emission area may be understood as the opening OP of the pixel defining layer PDL corresponding to each of the first sub-pixel SP1, the second sub-pixel SP2, and the third sub-pixel SP3.

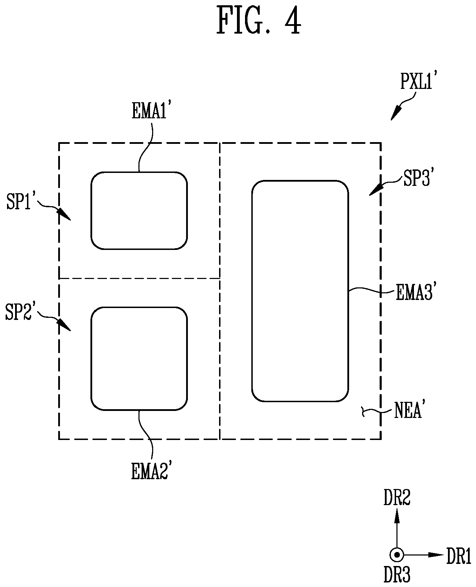

FIG. 4 is a plan view illustrating aspects of one of the pixels of FIG. 2 according to some embodiments.

Referring to FIG. 4, a first pixel PXL1' may include first to third sub-pixels SP1' to SP3'.

The first sub-pixel SP1' may include a first emission area EMA1' and a non-emission area NEA' around the first emission area EMA1'. The second sub-pixel SP2' may include a second emission area EMA2' and a non-emission area NEA' around the second emission area EMA2'. The third sub-pixel SP3' may include a third emission area EMA3' and a non-emission area NEA' around the third emission area EMA3'.

The first sub-pixel SP1' and the second sub-pixel SP2' may be arranged in the second direction DR2. The third sub-pixel SP3' may be arranged in the first direction DR1 with respect to each of the first and second sub-pixels SP1' and SP2'.

The second sub-pixel SP2' may have an area greater than that of the first sub-pixel SP1', and the third sub-pixel SP3' may have an area greater than that of the second sub-pixel SP2'. Accordingly, the second emission area EMA2' may have an area greater than the first emission area EMA1', and the third emission area EMA3' may have an area greater than that of the second emission area EMA2'. However, embodiments are not limited thereto. For example, the first and second sub-pixels SP1' and SP2' may have substantially the same area, and the third sub-pixel SP3' may have an area greater than that of each of the first and second sub-pixels SP1' and SP2'. As described above, the areas of the first to third sub-pixels SP1' to SP3' may vary according to embodiments.

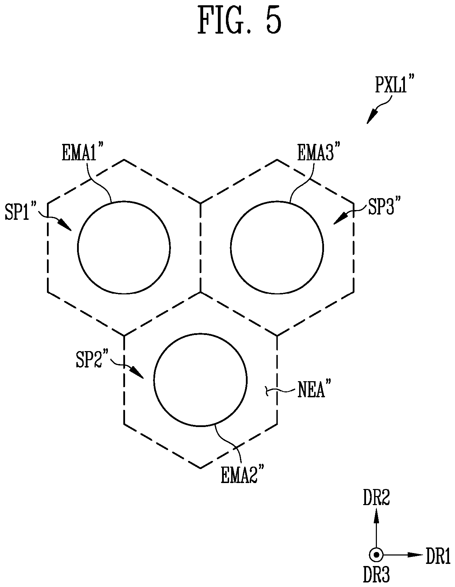

FIG. 5 is a plan view illustrating aspects of one of the pixels of FIG. 2 according to some embodiments.

Referring to FIG. 5, a first pixel PXL1" may include first to third sub-pixels SP1" to SP3". The first sub-pixel SP1" may include a first emission area EMA1" and a non-emission area NEA" around the first emission area EMA1". The second sub-pixel SP2" may include a second emission area EMA2" and a non-emission area NEA" around the second emission area EMA2". The third sub-pixel SP3" may include a third emission area EMA3" and a non-emission area NEA" around the third emission area EMA3".

The first to third sub-pixels SP1" to SP3" may have polygonal shapes when viewed in the third direction DR3. For example, shapes of the first to third sub-pixels SP1" to SP3" may be hexagonal shapes as shown in FIG. 5.

The first to third emission areas EMA1" to EMA3" may have circular shapes when viewed in the third direction DR3. However, embodiments according to the present disclosure are not limited thereto. For example, each of the first to third emission areas EMA1" to EMA3" may have a polygonal shape.

The first and third sub-pixels SP1" and SP3" may be arranged in the first direction DR1. The second sub-pixel SP2" may be arranged in a direction inclined by an acute angle based on the second direction DR2 (or a diagonal direction) with respect to the first sub-pixel SP1".

An example arrangement of the sub-pixels is shown in FIGS. 3 to 5, and embodiments are not limited thereto. Each pixel PXL may include two or more sub-pixels SP, the sub-pixels SP may be arranged in various methods, the respective sub-pixels SP may have various shapes, and respective emission areas EMA1, EMA2, and EMA3 thereof may also have various shapes.

Hereinafter, the display device 100 including a barrier layer BAR is described with reference to FIGS. 6 to 12. Some content that may overlap the content described above is briefly described or is not repeated.

FIG. 6 is a schematic cross-sectional view illustrating an arrangement relationship between a barrier layer and other layers adjacent thereto according to some embodiments.

FIGS. 7, 11, and 12 are schematic cross-sectional views illustrating a display device according to some embodiments. FIGS. 7, 11, and 12 respectively show display devices 100 according to different embodiments. FIGS. 7, 11, and 12 illustrate the alignment key area AKA, the pad area PDA, and the display area DA. FIGS. 7, 11, and 12 respectively show a cross-sectional view taken along the line A-A' of FIG. 1, a cross-sectional view taken along the line B-B' of FIG. 1, and a cross-sectional view taken along C-C' of FIG. 3. FIGS. 7, 11, and 12 show the substrate SUB, and the pixel circuit layer PCL, the intermediate conductive structure layer MCS, the light emitting element layer LDL, and the encapsulation layer TFE on the substrate SUB.

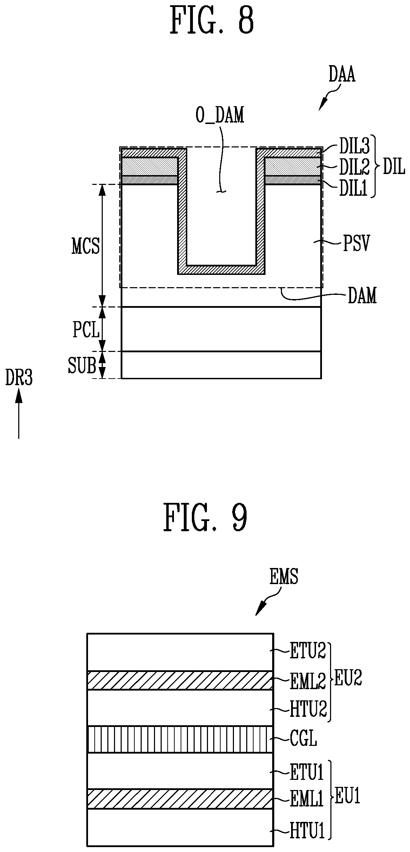

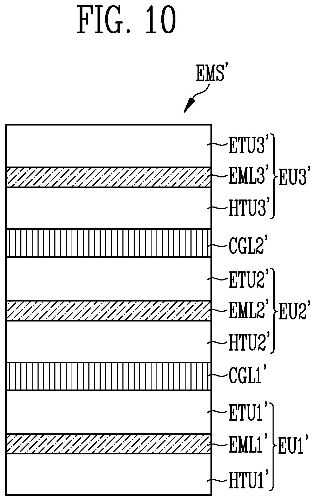

FIG. 8 is a schematic cross-sectional view illustrating a portion of a display device in a dam area according to some embodiments. FIGS. 9 and 10 are schematic cross-sectional views illustrating a light emitting structure according to some embodiments.

Referring to FIG. 6, the display device 100 according to some embodiments further includes the barrier layer BAR.

According to some embodiments, the barrier layer BAR may be located between the anode electrode AE and a reflective layer MR. The barrier layer BAR may be electrically connected to the reflective layer MR and may be electrically connected to the anode electrode AE. The barrier layer BAR may be a path through which an anode signal (or voltage) is supplied for the light emitting element LD to emit light.

The barrier layer BAR may be a barrier structure for preventing or relatively reducing damage to the anode electrode AE. For example, the barrier layer BAR may be directly adjacent to a portion of the anode electrode AE, and may allow the anode electrode AE not to be directly adjacent to the reflective layer MR.

The anode electrode AE may include the anode exposure area AEA exposed by the pixel defining layer PDL, and an anode cover area ACA covered by the pixel defining layer PDL. According to some embodiments, the barrier layer BAR may overlap the reflective layer MR and the anode electrode AE in a plan view (for example, along the third direction DR3) in the anode cover area ACA. The barrier layer BAR may not overlap the anode exposure area AEA in a plan view. The barrier layer BAR may not overlap a step forming layer SFL in a plan view. According to some embodiments, the reflective layer MR may overlap the anode electrode AE in each of the anode exposure area AEA and the anode cover area ACA in a plan view.

The anode electrode AE includes a transparent conductive material. For example, the anode electrode AE includes a transparent conductive material including oxide. For example, the transparent conductive material may include one or more of a group of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂). According to some embodiments, the anode electrode AE may be an electrode layer including ITO. However, embodiments according to the present disclosure are not necessarily limited thereto.

According to some embodiments, a portion of light emitted by the light emitting structure EMS may pass through the anode electrode AE and may be applied to the reflective layer MR, and the applied light may be reflected by the reflective layer MR, may pass through the anode electrode AE again, and may be emitted to the outside (for example, along the third direction DR3). According to some embodiments, because the anode electrode AE includes a transparent conductive material, even though the light application path is defined between the light emitting structure EMS and the reflective layer MR, light loss may be relatively reduced. Accordingly, light output efficiency of the display device 100 may be relatively improved, and a luminance characteristic may be relatively improved.

According to some embodiments, the barrier layer BAR is interposed between the anode electrode AE and the reflective layer MR. Accordingly, the anode electrode AE and the reflective layer MR are physically spaced apart from each other.

Experimentally, when the reflective layer MR and the anode electrode AE including a transparent conductive material including oxide are directly adjacent to each other, in an area where the anode electrode AE and the reflective layer MR are adjacent to each other during the manufacturing process of the display device 100, a risk that at least a portion of an uppermost portion of the reflective layer MR may be oxidized may exist, and thus an oxide layer may be formed in a portion of the reflective layer MR. For example, when the uppermost portion of the reflective layer MR includes a metal material (for example, aluminium), a layer including a metal oxide (for example, aluminium oxide) may be formed on the uppermost portion of the reflective layer MR. In this case, a risk that a physical property (for example, a resistance) of the reflective layer MR may change may occur.

However, according to some embodiments, the anode electrode AE and the reflective layer MR are physically spaced apart from each other, and even though the anode electrode AE includes a transparent conductive material including oxide, a risk that a structure related to the reflective layer MR may be distorted may be relatively reduced, and thus reliability of an electrical signal (for example, the anode signal) supplied to the light emitting element LD may be improved.

Next, a display device 100 including a barrier layer BAR according to some embodiments is described with reference to FIGS. 7 to 10.

Referring to FIGS. 7 to 10, the display device 100 may include the substrate SUB, the pixel circuit layer PCL, the intermediate conductive structure layer MCS, the light emitting element layer LDL, and the encapsulation layer TFE located on the substrate SUB.

The pixel circuit layer PCL may include the lower pad layer PAD_L located in the pad area PDA. The lower pad layer PAD_L may be formed in the same process and may include the same conductive material as at least a portion (for example, first and second conductive patterns CP1 and CP2) of a conductive layer formed in the display area DA. The lower pad layer PAD_L may be electrically connected to the upper pad layer PAD_U and may be electrically connected to another configuration such as a driver integrated circuit.

The substrate SUB and the pixel circuit layer PCL may include the circuit elements of each of the first to third sub-pixels SP1 to SP3 located in the display area DA. For example, the substrate SUB and the pixel circuit layer PCL may include a transistor T_SP. The transistor T_SP may include a transistor T_SP1 of the first sub-pixel SP1, a transistor T_SP2 of the second sub-pixel SP2, and a transistor T_SP3 of the third sub-pixel SP3.

Each of the transistors T_SP of the first to third sub-pixels SP1 to SP3 may include a source area SRA, a drain area DRA, and a gate electrode GE.

The source area SRA and the drain area DRA may be located in the substrate SUB. A well WL formed through an ion implantation process may be located in the substrate SUB, and the source area SRA and the drain area DRA may be arranged to be spaced apart from each other in the well WL. An area between the source area SRA and the drain area DRA in the well WL may be defined as a channel area.

The gate electrode GE may overlap the channel area between the source area SRA and the drain area DRA and may be located in the pixel circuit layer PCL. The gate electrode GE may be spaced apart from the well WL or the channel area by an insulating material such as a gate insulating layer GI. The gate electrode GE may include a conductive material.

A plurality of layers included in the pixel circuit layer PCL may include insulating layers and conductive patterns located between the insulating layers, and such conductive patterns may include the first and second conductive patterns CP1 and CP2. The first conductive pattern CP1 may be electrically connected to the drain area DRA through a drain connection portion DRC passing through one or more insulating layers. The second conductive pattern CP2 may be electrically connected to the source area SRA through a source connection portion SRC passing through one or more insulating layers.

As the gate electrode GE and the first and second conductive patterns CP1 and CP2 are connected to different circuit elements and/or lines, the respective transistors T_SP of the first to third sub-pixels SP1 to SP3 may be provided as one of the transistors of the first to third sub-pixels SP1 to SP3.

The pixel circuit layer PCL may include an interlayer insulating layer ILD arranged across the pad area PDA, the alignment key area AKA, and the display area DA. The interlayer insulating layer ILD may cover different configurations of the pixel circuit layer PCL. The interlayer insulating layer ILD may include an inorganic material. For example, the interlayer insulating layer ILD may include a multilayer structure including a first interlayer insulating layer including SiCxNy and a second interlayer insulating layer including SixNy. However, embodiments according to the present disclosure are not limited thereto.

According to some embodiments, the pixel circuit layer PCL may further include a via layer, a planarization layer, a reflective electrode, and/or the like.

The intermediate conductive structure layer MCS may be located on the pixel circuit layer PCL (for example, the interlayer insulating layer ILD). According to some embodiments, the intermediate conductive structure layer MCS may be a layer including the reflective layer MR.

The intermediate conductive structure layer MCS may include the upper pad layer PAD_U located in the pad area PDA. According to some embodiments, the upper pad layer PAD_U may include a plurality of layers. For example, the upper pad layer PAD_U may include a first upper pad layer PAD_U1, a second upper pad layer PAD_U2, and a third upper pad layer PAD_U3.

The upper pad layer PAD_U may be formed in the same process and may include the same conductive material as at least a portion of a conductive layer formed in the alignment key area AKA (for example, a base alignment key ALL). For example, the first upper pad layer PAD_U1 may be formed in the same process and may include the same material as a first base alignment key ALL1. The second upper pad layer PAD_U2 may be formed in the same process and may include the same material as a second base alignment key ALL2. The third upper pad layer PAD_U3 may be formed in the same process and may include the same material as a third base alignment key ALL3.

The upper pad layer PAD_U may be electrically connected to the lower pad layer PAD_L by passing through at least a portion of the interlayer insulating layer ILD and the like. Accordingly, the upper pad layer PAD_U may be electrically connected to another configuration such as a driver integrated circuit.

The upper pad layer PAD_U may be exposed at a pad opening O_PD formed by a protective layer PSV. According to some embodiments, an additional conductive layer may be formed on the upper pad layer PAD_U, and the additional conductive layer may be electrically connected to the light emitting element LD. According to some embodiments, the additional conductive layer may be formed in the same process and may include the same material as other conductive layers such as the cathode electrode CE. However, embodiments according to the present disclosure are not limited thereto.

The intermediate conductive structure layer MCS may include the base alignment key ALL and a lower alignment key AKL_L located in the alignment key area AKA. According to some embodiments, the base alignment key ALL may include a plurality of layers. For example, the base alignment key ALL may include a first base alignment key ALL1, a second base alignment key ALL2, and a third base alignment key ALL3. According to some embodiments, the lower alignment key AKL_L may include a plurality of layers. For example, the lower alignment key AKL_L may include a first lower alignment key AKL_L1, a second lower alignment key AKL_L2, a third lower alignment key AKL_L3, a fourth lower alignment key AKL_L4, and a fifth lower alignment key AKL_L5.

The lower alignment key AKL_L may be formed in the same process and may include the same material as at least a portion of a conductive layer (for example, the reflective layer MR) formed in the display area DA. For example, the first lower alignment key AKL_L1 may be formed in the same process and may include the same material as a first lower reflective layer MR_L1. The second lower alignment key AKL_L2 may be formed in the same process and may include the same material as a second lower reflective layer MR_L2. The third lower alignment key AKL_L3 may be formed in the same process and may include the same material as the step forming layer SFL. The fourth lower alignment key AKL_L4 may be formed in the same process and may include the same material as an interlayer lower reflective layer MR_U. The fifth lower alignment key AKL_L5 may be formed in the same process and may include the same material as an upper reflective layer MR_R.

According to some embodiments, at least a portion of the lower alignment key AKL_L may surround at least a portion of an alignment key opening O_AK formed by the protective layer PSV. Accordingly, at least a portion of the lower alignment key AKL_L may be adjacent (for example, directly adjacent) to an insulating layer provided in the alignment key opening O_AK. The insulating layer AKL_I may include a first insulating layer AKL_I1, a second insulating layer AKL_I2, and a third insulating layer AKL_I3. At least a portion of the third insulating layer AKL_I3 may be located on a side surface of the lower alignment key AKL_L and may be directly adjacent to the lower alignment key AKL_L. Accordingly, a structure in which the lower alignment key AKL_L may be identified from the outside may be provided, and damage to the lower alignment key AKL_L may be prevented or relatively reduced.

The intermediate conductive structure layer MCS may be located on the pixel circuit layer PCL. The intermediate conductive structure layer MCS may include the reflective layer MR located in the display area DA and the protective layer PSV arranged throughout the display device 100.

The reflective layer MR may be located in each of the first to third sub-pixels SP1 to SP3. The reflective layer MR may include the first lower reflective layer MR_L1, the second lower reflective layer MR_L2 on the first lower reflective layer MR_L1, the interlayer lower reflective layer MR_U on the second lower reflective layer MR_L2, and the upper reflective layer MR_R on the interlayer lower reflective layer MR_U. According to some embodiments, the reflective layer MR may further include the step forming layer SFL between the second lower reflective layer MR_L2 and the interlayer lower reflective layer MR_U in the first sub-pixel SP1.

The reflective layer MR may be electrically connected to the transistors T_SP of the respective first to third sub-pixels SP1 to SP3.

The reflective layer MR may function as a full mirror that reflects the light emitted from the light emitting structure EMS toward a display screen (or the cover window CW). At least a portion of the reflective layer MR may include metal materials suitable for reflecting light. For example, the metal materials may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and/or an alloy of two or more materials selected from them. For example, the first lower reflective layer MR_L1 may include titanium (Ti), the second lower reflective layer MR_L2 may include titanium nitride (TiN), and the interlayer lower reflective layer MR_U may include titanium (Ti), and the upper reflective layer MR_R may include aluminium (Al). However, embodiments according to the present disclosure are not limited thereto.

The step forming layer SFL may change a height of a portion of a layer forming the reflective layer MR in the first sub-pixel SP1. For example, the step forming layer SFL may overlap the anode exposure area AEA in a plan view, and a height at which the interlayer lower reflective layer MR_U is located may be changed. According to some embodiments, the step forming layer SFL may be referred to as a buffer layer.

According to some embodiments, the step forming layer SFL may include an insulating material. For example, the insulating material may include an organic material or an inorganic material. The step forming layer SFL may include tetra ethyl ortho silicate (TEOS). However, embodiments according to the present disclosure are not limited thereto.

The reflective layer MR may function as a full mirror, and the cathode electrode CE may function as a half mirror. The light emitted from the light emitting layer of the light emitting structure EMS may be amplified by at least partially reciprocating between the corresponding reflective layer MR and the cathode electrode CE, and the amplified light may be output through the cathode electrode CE. As described above, a distance between each reflective layer MR and the cathode electrode CE may be understood as a resonance distance for the light emitted from the light emitting layer of the corresponding light emitting structure EMS.

The first sub-pixel SP1 may have a resonance distance shorter than that of another sub-pixel by the step forming layer SFL. The resonance distance adjusted as described above may allow light of a specific wavelength range (for example, red color light) to be effectively and efficiently amplified. Accordingly, the first sub-pixel SP1 may effectively and efficiently output the light of the corresponding wavelength range.

In FIG. 7, the step forming layer SFL is located only in the first sub-pixel SP1, but embodiments according to the present disclosure are not limited thereto. For example, a layer corresponding to the step forming layer SFL may be formed in at least one of the second and third sub-pixels SP2 and SP3.

The upper reflective layer MR_R may be electrically connected to the anode electrode AE through the barrier layer BAR. Because the reflective layer MR may be electrically connected to the transistor T_SP, an electrical signal provided by the transistor T_SP may be supplied to the anode electrode AE through the barrier layer BAR.

According to some embodiments, the upper reflective layer MR_R may be directly adjacent to (for example, contact) the barrier layer BAR. The upper reflective layer MR_R may be spaced apart from the anode electrode AE by the barrier layer BAR.

The protective layer PSV may be located on the pixel circuit layer PCL. The protective layer PSV may cover different configurations (for example, the reflective layer MR) of the intermediate conductive structure layer MCS. The protective layer PSV may also be a planarization layer. The protective layer PSV may include an insulating material such as an organic material or an inorganic material. According to some embodiments, the protective layer PSV may include TEOS. However, embodiments according to the present disclosure are not limited thereto.

The protective layer PSV may form the pad opening O_PD and the alignment key opening O_AK, and may form an opening exposing the reflective layer MR (for example, the upper reflective layer MR_R). According to some embodiments, a trench TRCH may be formed in at least a portion of the protective layer PSV.

The light emitting element layer LDL may be located on the intermediate conductive structure layer MCS. The light emitting element layer LDL may include the upper alignment key AKL_U, the insulating layer AKL_I, the barrier layer BAR, the anode electrode AE, the pixel defining layer PDL, the light emitting structure EMS, and the cathode electrode CE.

The upper alignment key AKL_U may be located on the protective layer PSV in the alignment key area AKA. The upper alignment key AKL_U may overlap the lower alignment key AKL_L in a plan view. A side surface of the upper alignment key AKL_U may be directly adjacent to the third insulating layer AKL_I3.

The upper alignment key AKL_U may be formed in the same process and may include the same material as the anode electrode AE.

The insulating layer AKL_I may be located on the upper alignment key AKL_U. At least a portion (for example, the third insulating layer AKL_I3) of the insulating layer AKL_I may be provided in the alignment key opening O_AK and may cover a side surface of the lower alignment key AKL_L.

The insulating layer AKL_I may be formed in the same process and may include the same material as the pixel defining layer PDL in the display area DA. For example, the first insulating layer AKL_I1 may be formed in the same process and may include the same material as a first pixel defining layer PDL1. The second insulating layer AKL_I2 may be formed in the same process and may include the same material as a second pixel defining layer PDL2. The third insulating layer AKL_I3 may be formed in the same process and may include the same material as a third pixel defining layer PDL3.

The barrier layer BAR may be located on the protective layer PSV. According to some embodiments, at least a portion of the barrier layer BAR may be located in an opening formed in the protective layer PSV. The barrier layer BAR may be directly adjacent to the reflective layer MR (for example, the upper reflective layer MR_R). The barrier layer BAR may form a contact portion electrically connected to the reflective layer MR.

The barrier layer BAR may include a conductive material. The barrier layer BAR may include a material that is robust to an oxidation risk. For example, the barrier layer BAR may include titanium nitride (TiN). However, embodiments according to the present disclosure are not limited thereto.

A lower surface of the barrier layer BAR may be directly adjacent to the reflective layer MR, and an upper surface of the barrier layer BAR may be directly adjacent to the anode electrode AE. As described above, the barrier layer BAR may relatively reduce a risk that an oxide layer is formed in the reflective layer MR when forming the anode electrode AE.

According to some embodiments, the barrier layer BAR may not overlap the anode exposure area AEA in a plan view. The barrier layer BAR may overlap the pixel defining layer PDL in a plan view. As the barrier layer BAR does not overlap the anode exposure area AEA, the barrier layer BAR may not be located on an optical path, and light output efficiency may be relatively improved.

The anode electrode AE may be located on the protective layer PSV in the display area DA. At least a portion of the anode electrode AE may be located on the barrier layer BAR. According to some embodiments, the anode electrode AE may include a first anode electrode AE1 included in the first sub-pixel SP1, a second anode electrode AE2 included in the second sub-pixel SP2, and a third anode electrode AE3 included in the third sub-pixel SP3.

The anode electrode AE may be electrically connected to the reflective layer MR through the barrier layer BAR. Accordingly, the first to third anode electrodes AE1 to AE3 may receive the anode signal through the transistors T_SP.

The anode electrode AE may be exposed by the pixel defining layer PDL in the anode exposure area AEA, and may be covered by the pixel defining layer PDL (for example, the first pixel defining layer PDL1) in an area except for the anode exposure area AEA.

As described above, because the anode electrode AE includes a transparent conductive material, the light emitting element LD having excellent light output efficiency may be provided. In addition, even in a case where the anode electrode AE includes a transparent conductive material including oxide, the barrier layer BAR may be interposed between the anode electrode AE and the reflective layer MR, and thus formation of a structure that is not intended to be manufactured, such as formation of an oxide layer on an upper surface of the reflective layer MR by the anode electrode AE (for example, oxide) may be prevented or relatively reduced.

The pixel defining layer PDL may expose at least a portion of the anode electrode AE. The pixel defining layer PDL may include a lower pixel defining layer LPDL and an upper pixel defining layer UPDL on the lower pixel defining layer LPDL. The lower pixel defining layer LPDL may include a first pixel defining layer PDL1 and a second pixel defining layer PDL2, and the upper pixel defining layer UPDL may include a third pixel defining layer PDL3.

Each of the first to third pixel defining layers PDL1 to PDL3 may include at least one of silicon oxide (SiOx) and silicon nitride (SiNx). For example, the first pixel defining layer PDL1 and the third pixel defining layer PDL3 may include silicon nitride (SiNx). The second pixel defining layer PDL2 may include silicon oxide (SiOx). However, embodiments according to the present disclosure are not limited thereto.

The first to third pixel defining layers PDL1 to PDL3 may have a step shape of cross-section in an area adjacent to the anode exposure area AEA.

According to some embodiments, the lower pixel defining layer LPDL may be provided (for example, located) in an opening formed by the protective layer PSV as an area where the barrier layer BAR is located. For example, the first pixel defining layer PDL1 may cover an upper surface of the anode electrode AE in the opening formed by the protective layer PSV, and the second pixel defining layer PDL2 may fill the opening formed by the protective layer PSV.

A separator for forming a discontinuous portion in the light emitting structure EMS may be formed in a boundary area between the sub-pixels SP adjacent to each other. According to some embodiments, a trench TRCH may function as the separator. For example, at least a portion of the light emitting structure EMS may be disconnected or bent by the trench TRCH.

According to some embodiments, the trench TRCH may pass through the pixel defining layer PDL and partially pass through the protective layer PSV. Two trenches TRCH may be located between adjacent sub-pixels SP. However, the number of trenches TRCH is not limited thereto.

A portion of a plurality of layers stacked in the light emitting structure EMS may be disconnected or bent due to the discontinuous portion formed by the trench TRCH. For example, at least one charge generation layer included in the light emitting structure EMS may be disconnected at the discontinuous portion formed by the trench TRCH.

According to some embodiments, the light emitting structure EMS may be formed through processes such as vacuum deposition and inkjet printing. In this case, the same materials as the light emitting structure EMS may be positioned on bottom surfaces of the trench TRCH adjacent to the protective layer PSV.

According to some embodiments, the separator may be provided in another form as well as the trench TRCH. For example, additional inorganic insulating pattern layers may be located on the pixel defining layer PDL, and thus the separator may be provided. In this case, the additional inorganic insulating pattern layers may have a "T" shape or "I" shape of cross-section.

The light emitting structure EMS may be located on the anode electrodes AE exposed in the anode exposure area AEA of the pixel defining layer PDL. The light emitting structure EMS may be arranged entirely across the first to third sub-pixels SP1 to SP3. As described above, the light emitting structure EMS may be at least partially disconnected or bent between adjacent sub-pixels SP by the separator (for example, the trench TRCH). Accordingly, when the display device 100 is operated, a current flowing out from each of the first to third sub-pixels SP1 to SP3 to a sub-pixel adjacent thereto through the layers included in the light emitting structure EMS may be decreased. Accordingly, the first to third light emitting elements LD1 to LD3 may operate with relatively high reliability.

The cathode electrode CE may be located on the light emitting structure EMS. The cathode electrode CE may be commonly provided to the first to third sub-pixels SP1 to SP3. The cathode electrode CE may function as a half mirror that partially transmits and partially reflects the light emitted from the light emitting structure EMS.

The first anode electrode AE1, a portion of the light emitting structure EMS overlapping the first anode electrode AE1, and a portion of the cathode electrode CE overlapping the first anode electrode AE1 may configure the light emitting element LD of the first sub-pixel SP1. The second anode electrode AE2, a portion of the light emitting structure EMS overlapping the second anode electrode AE2, and a portion of the cathode electrode CE overlapping the second anode electrode AE2 may configure the light emitting element LD of the second sub-pixel SP2. The third anode electrode AE3, a portion of the light emitting structure EMS overlapping the third anode electrode AE3, and a portion of the cathode electrode CE overlapping the third anode electrode AE3 may configure the light emitting element LD of the third sub-pixel SP3.

The encapsulation layer TFE may be located on the cathode electrode CE. The encapsulation layer TFE may prevent or relatively reduce instances of contaminants such as oxygen, moisture, and/or the like permeating into the light emitting element layer LDL. Meanwhile, according to some embodiments, a range covered by the encapsulation layer TFE is not limited to the display area DA. For example, according to some embodiments, a portion of the encapsulation layer TFE may cover at least one of the dam area DAA, the alignment key area AKA, and the pad area PDA.

Referring to FIG. 8, the display device 100 according to some embodiments may include the dam structure DAM formed in the dam area DAA.

The dam structure DAM may be formed by a dam opening O_DAM formed in a dam insulating layer DIL and the protective layer PSV. For example, the dam opening O_DAM partially passing through the protective layer PSV may be formed in the protective layer PSV. The dam insulating layer DIL may be located on the protective layer PSV, and at least a portion of the dam insulating layer DIL may be provided in the dam opening O_DAM. A third dam insulating layer DIL3 may form a clad structure covering a side surface of first and second dam insulating layers DIL1 and DIL2 and the protective layer PSV. The side surface defining the clad structure may include tapered surfaces. Accordingly, the dam structure DAM relatively protruding in a direction (for example, the third direction DR3) may be formed.

The dam insulating layer DIL may include a plurality of layers. For example, the dam insulating layer DIL may include a first dam insulating layer DIL1, a second dam insulating layer DIL2, and a third dam insulating layer DIL3.

The dam insulating layer DIL may be formed in the same process and may include the same material as the pixel defining layer PDL. For example, the first dam insulating layer DIL1 may be formed in the same process and may include the same material as the first pixel defining layer PDL1. The second dam insulating layer DIL2 may be formed in the same process and may include the same material as the second pixel defining layer PDL2. The third dam insulating layer DIL3 may be formed in the same process and may include the same material as the third pixel defining layer PDL3.

Referring to FIG. 9, the light emitting structure EMS may have a tandem structure in which first and second light emitting units EU1 and EU2 are stacked. The light emitting structure EMS may be configured substantially identically in the first to third sub-pixels SP1 to SP3.

Each of the first and second light emitting units EU1 and EU2 may include at least one light emitting layer that generates light according to an applied current. The first light emitting unit EU1 may include a first light emitting layer EML1, a first electron transport part ETU1, and a first hole transport part HTU1. The first light emitting layer EML1 may be located between the first electron transport part ETU1 and the first hole transport part HTU1. The second light emitting unit EU2 may include a second light emitting layer EML2, a second electron transport part ETU2, and a second hole transport part HTU2. The second light emitting layer EML2 may be located between the second electron transport part ETU2 and the second hole transport part HTU2.

Each of the first and second hole transport parts HTU1 and HTU2 may include at least one of a hole injection layer and a hole transport layer, and may further include a hole buffer layer, an electron blocking layer, and the like if necessary. The first and second hole transport parts HTU1 and HTU2 may have configurations equal to each other or different from each other.

Each of the first and second electron transport parts ETU1 and ETU2 may include at least one of an electron injection layer and an electron transport layer, and may further include an electron buffer layer, a hole blocking layer, and the like according to some embodiments. The first and second electron transport parts ETU1 and ETU2 may have configurations equal to each other or different from each other.

A connection layer, which may be provided in a form of a charge generation layer CGL, may be located between the first light emitting unit EU1 and the second light emitting unit EU2 to connect the first light emitting unit EU1 and the second light emitting unit EU2 to each other. According to some embodiments, the charge generation layer CGL may have a stack structure of a p dopant layer and an n dopant layer. For example, the p dopant layer may include a p-type dopant such as HAT-CN, TCNQ, and NDP-9, and the n dopant layer may include an alkali metal, an alkaline earth metal, a lanthanide metal, or a combination thereof. However, embodiments are not limited thereto.

According to some embodiments, the first light emitting layer EML1 and the second light emitting layer EML2 may generate light of different colors. Light emitted from each of the first light emitting layer EML1 and the second light emitting layer EML2 may be mixed and viewed as white light. For example, the first light emitting layer EML1 may generate light of a blue color, and the second light emitting layer EML2 may generate light of a yellow color. According to some embodiments, the second light emitting layer EML2 may include a structure in which a first sub light emitting layer configured to generate light of a red color and a second sub light emitting layer configured to generate light of a green color are stacked. The light of the red color and the light of the green color may be mixed, and thus the light of the yellow color may be provided. In this case, an intermediate layer configured to perform a function of transporting holes and/or blocking transport of electrons may be further located between the first and second sub light emitting layers.

According to some embodiments, the first light emitting layer EML1 and the second light emitting layer EML2 may generate light of the same color.

The light emitting structure EMS may be formed through a method of vacuum deposition, inkjet printing, or the like, but embodiments are not limited thereto.

Referring to FIG. 10, the light emitting structure EMS' may have a tandem structure in which first to third light emitting units EU1' to EU3' are stacked. The light emitting structure EMS' may be configured substantially identically in the first to third sub-pixels SP1 to SP3.

Each of the first to third light emitting units EU1' to EU3' may include a light emitting layer that generates light according to an applied current. The first light emitting unit EU1' may include a first light emitting layer EML1', a first electron transport part ETU1', and a first hole transport part HTU1'. The first light emitting layer EML1' may be located between the first electron transport part ETU1' and the first hole transport part HTU1'. The second light emitting unit EU2' may include a second light emitting layer EML2', a second electron transport part ETU2', and a second hole transport part HTU2'. The second light emitting layer EML2' may be located between the second electron transport part ETU2' and the second hole transport part HTU2'. The third light emitting unit EU3' may include a third light emitting layer EML3', a third electron transport part ETU3', and a third hole transport part HTU3'. The third light emitting layer EML3' may be located between the third electron transport part ETU3' and the third hole transport part HTU3'.

Each of the first to third hole transport parts HTU1' to HTU3' may include at least one of a hole injection layer and a hole transport layer, and may further include a hole buffer layer, an electron blocking layer, and the like according to some embodiments. The first to third hole transport parts HTLIT to HTU3' may have configurations equal to each other or different from each other.

Each of the first to third electron transport parts ETU1' to ETU3' may include at least one of an electron injection layer and an electron transport layer, and may further include an electron buffer layer, a hole blocking layer, and the like, according to some embodiments. The first to third electron transport parts ETU1' to ETU3' may have configurations equal to each other or different from each other.

A first charge generation layer CGL1' is located between the first light emitting unit EU1' and the second light emitting unit EU2'. A second charge generation layer CGL2' is located between the second light emitting unit EU2' and the third light emitting unit EU3'.

According to some embodiments, the first to third light emitting layers EML1' to EML3' may generate light of different colors. Light emitted from each of the first to third light emitting layers EML1' to EML3' may be mixed and may be viewed as white light. For example, the first light emitting layer EML1' may generate light of a blue color, the second light emitting layer EML2' may generate light of a green color, and the third light emitting layer EML3' may generate light of a red color.

According to some embodiments, two or more of the first to third light emitting layers EML1' to EML3' may generate light of the same color.

Meanwhile, according to some embodiments, the light emitting structure EMS may include one light emitting unit in the light emitting element LD of each of the first to third sub-pixels SP1 to SP3. At this time, the light emitting unit included in each of the light emitting elements LD of the respective first to third sub-pixels SP1 to SP3 may be configured to emit light of different colors. For example, the light emitting unit of the light emitting element LD in the first sub-pixel SP1 may emit the light of the red color, the light emitting unit of the light emitting element LD in the second sub-pixel SP2 may emit the light of the green color, and the light emitting unit of the light emitting element LD in the third sub-pixel SP3 may emit the light of the blue color. In this case, the light emitting units of the first to third sub-pixels SP1 to SP3 may be separated from each other, and each of them may be located in the anode exposure area AEA exposed by the pixel defining layer PDL. In this case, at least a portion of the color filters CF may be omitted.

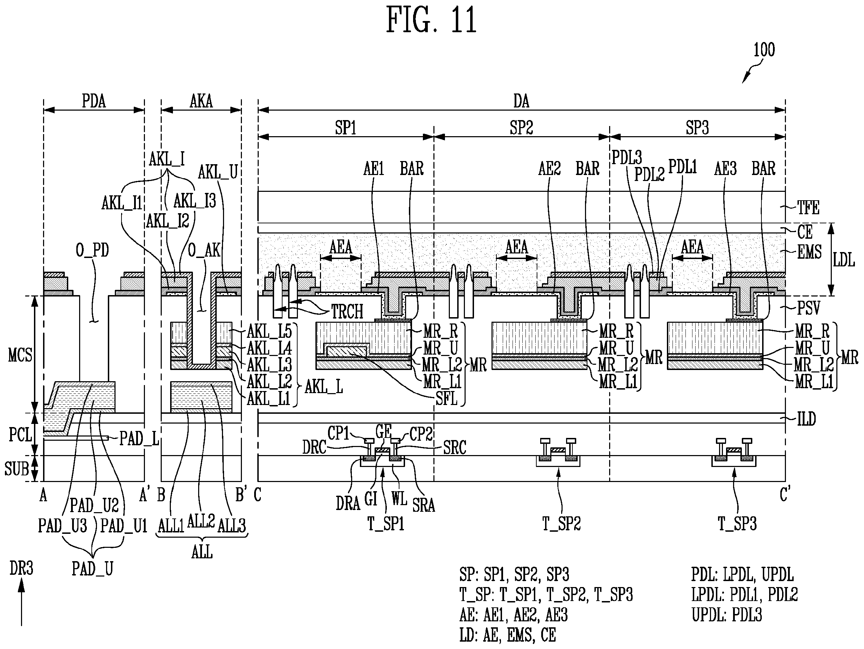

Next, a display device 100 including a barrier layer BAR according to some embodiments is described with reference to FIG. 11. For convenience of description, the display device 100 according to some embodiments is described based on a difference compared to the display device 100 according to some embodiments described above with reference to FIGS. 7 to 10.

The display device 100 according to the present embodiments is different from the display device 100 according to the embodiments described above, in that the barrier layer BAR is not located on the protective layer PSV.

The barrier layer BAR may be included in the intermediate conductive structure layer MCS. For example, the barrier layer BAR may be located on the reflective layer MR, and the protective layer PSV may be formed after the barrier layer BAR is formed.

A lower surface of the barrier layer BAR may entirely contact the reflective layer MR. At least a portion of an upper surface of the barrier layer BAR may be covered by the protective layer PSV. A portion of the upper surface of the barrier layer BAR exposed by the protective layer PSV may be directly adjacent to (for example, contact) the anode electrode AE.

Similarly to the embodiments described above, the barrier layer BAR separates the anode electrode AE and the reflective layer MR, and thus the light output efficiency may be relatively improved and the reliability of the electrical signal in the display device 100 may be improved. In addition, after the barrier layer BAR is formed, a process of forming an opening in the protective layer PSV may be performed, and thus the reflective layer MR may not be exposed. Accordingly, the reflective layer MR may be more closely protected.

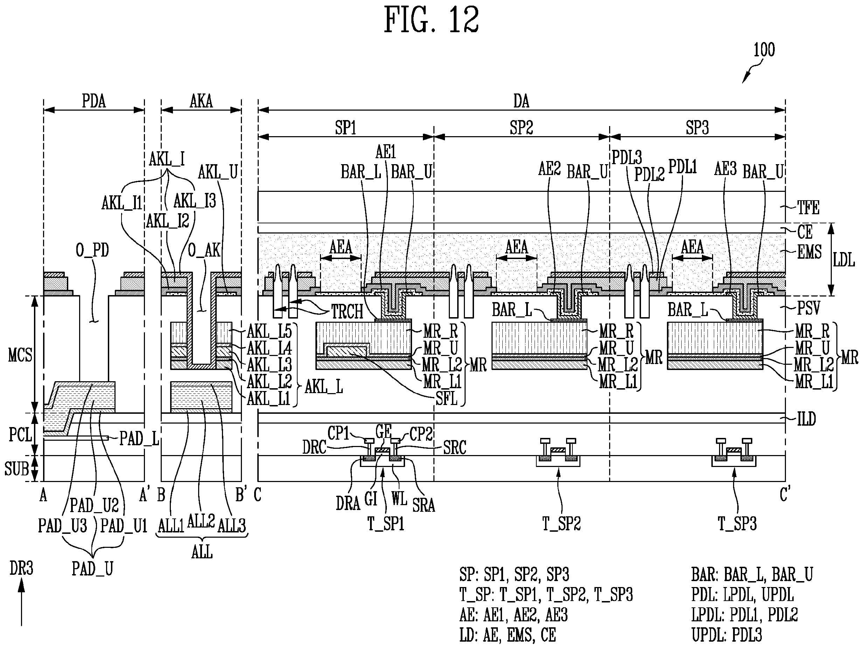

Next, a display device 100 including a barrier layer BAR according to some embodiments is described with reference to FIG. 12. For convenience of description, the display device 100 according to some embodiments is described based on a difference compared to the display device 100 according to some embodiments described above with reference to FIGS. 7 to 10.

The display device 100 according to the present embodiments is different from the display device 100 according to the embodiments described above, in that the barrier layer BAR includes a multilayer structure.

The barrier layer BAR may include a first barrier layer BAR_L and a second barrier layer BAR_U on the first barrier layer BAR_L.

The first barrier layer BAR_L may be a lower barrier layer and may be included in the intermediate conductive structure layer MCS. The first barrier layer BAR_L may have a structural characteristic corresponding to the barrier layer BAR described with reference to FIG. 11. For example, the protective layer PSV may be formed after the first barrier layer BAR_L is formed. A lower surface of the first barrier layer BAR_L may entirely contact the reflective layer MR. At least a portion of an upper surface of the first barrier layer BAR_L may be covered by the protective layer PSV. A portion of the upper surface of the first barrier layer BAR_L exposed by the protective layer PSV may be directly adjacent to (for example, contact) the second barrier layer BAR_U.

The second barrier layer BAR_U may be an upper barrier layer and may be included in the light emitting element layer LDL. The second barrier layer BAR_U may have a structural characteristic corresponding to the barrier layer BAR described with reference to FIG. 7. For example, the second barrier layer BAR_U may be patterned after the protective layer PSV is formed, and an upper surface of the second barrier layer BAR_U may be covered by the anode electrode AE.

According to some embodiments, the first barrier layer BAR_L and the second barrier layer BAR_U may be in contact with each other. The first barrier layer BAR_L and the second barrier layer BAR_U may be directly adjacent to each other at the opening formed by the protective layer PSV and may be electrically connected to each other.

Similarly to the embodiments described above, the first barrier layer BAR_L and the second barrier layer BAR_U separate the anode electrode AE and the reflective layer MR, and thus the light output efficiency may be relatively improved. Furthermore, because the barrier layer BAR includes a multilayer structure, the reliability of the electrical signal in the display device 100 may be further improved.

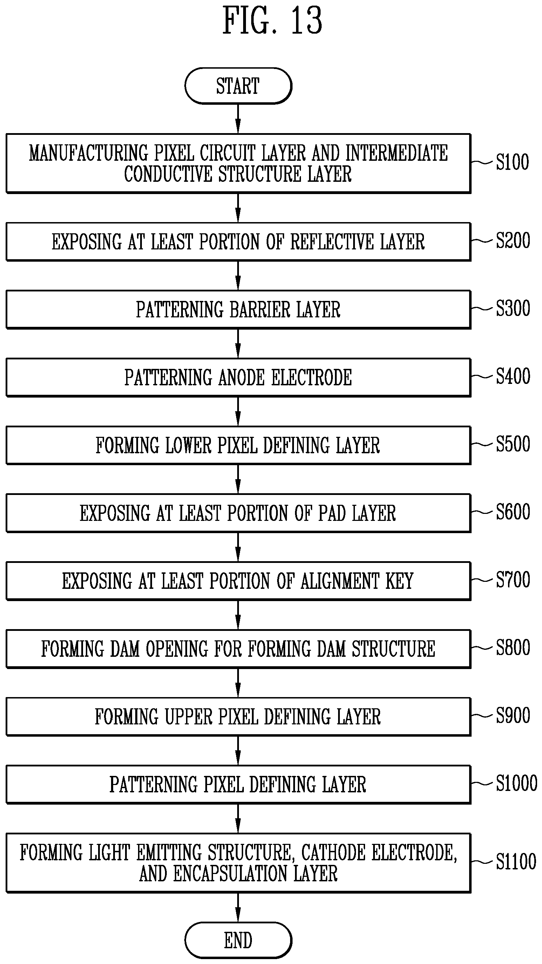

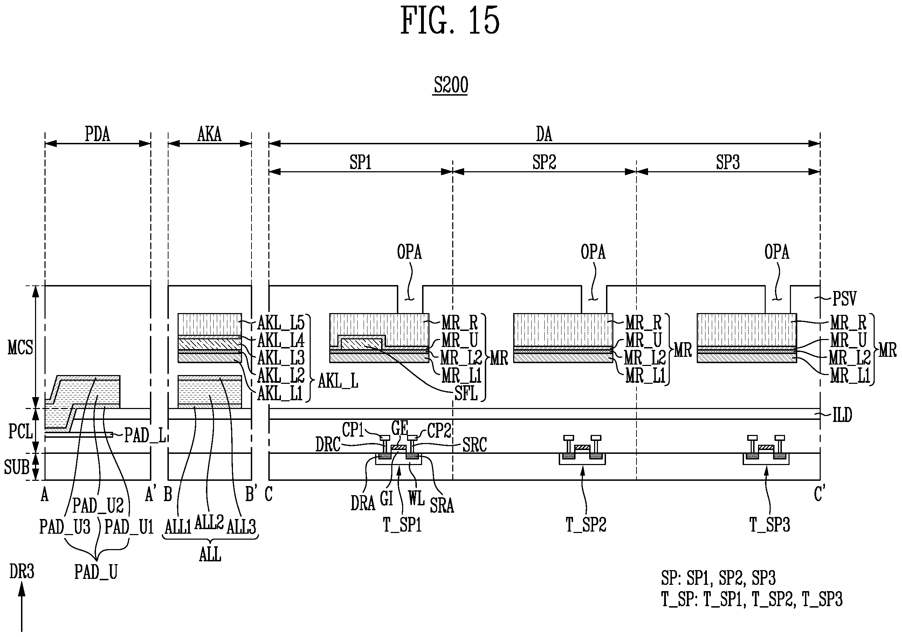

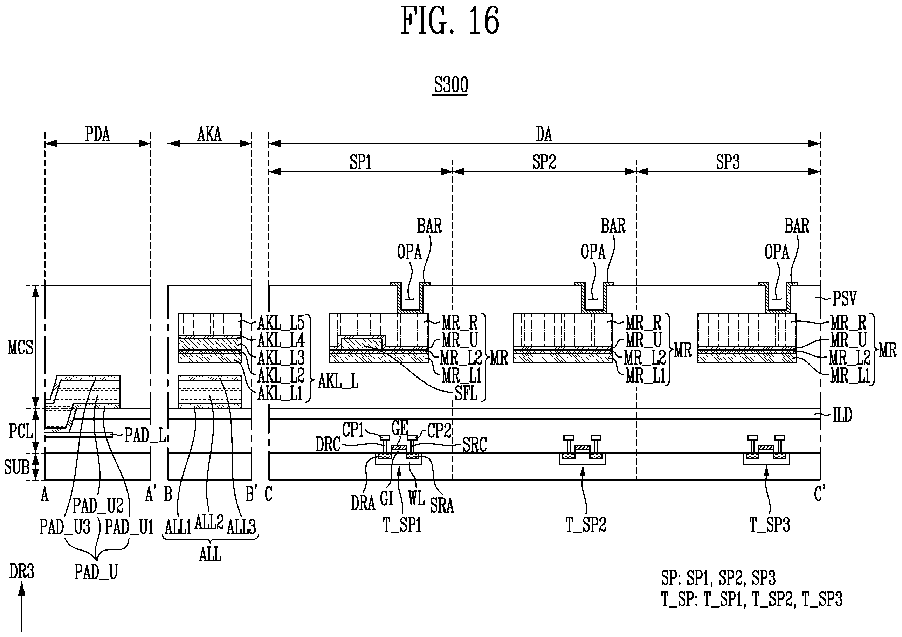

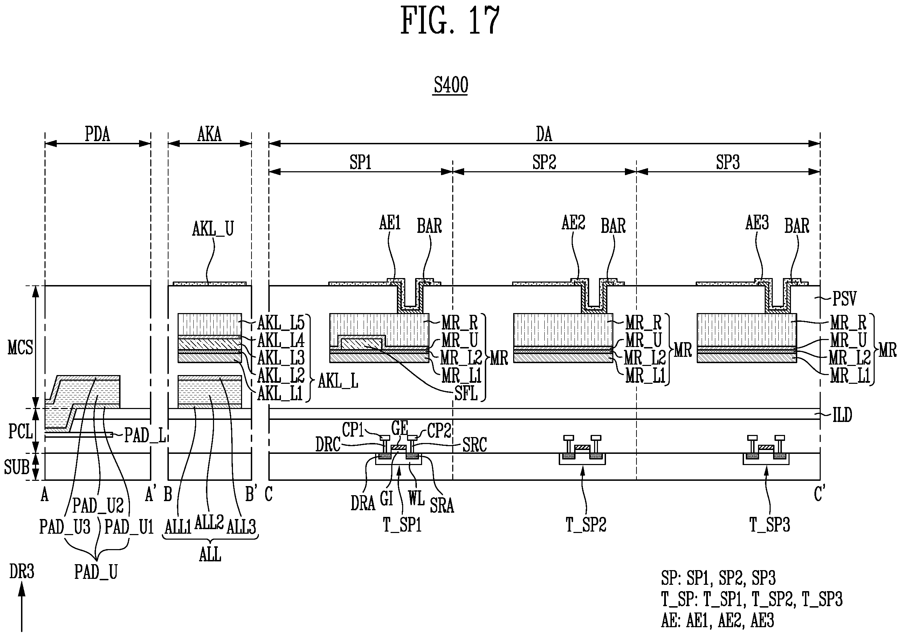

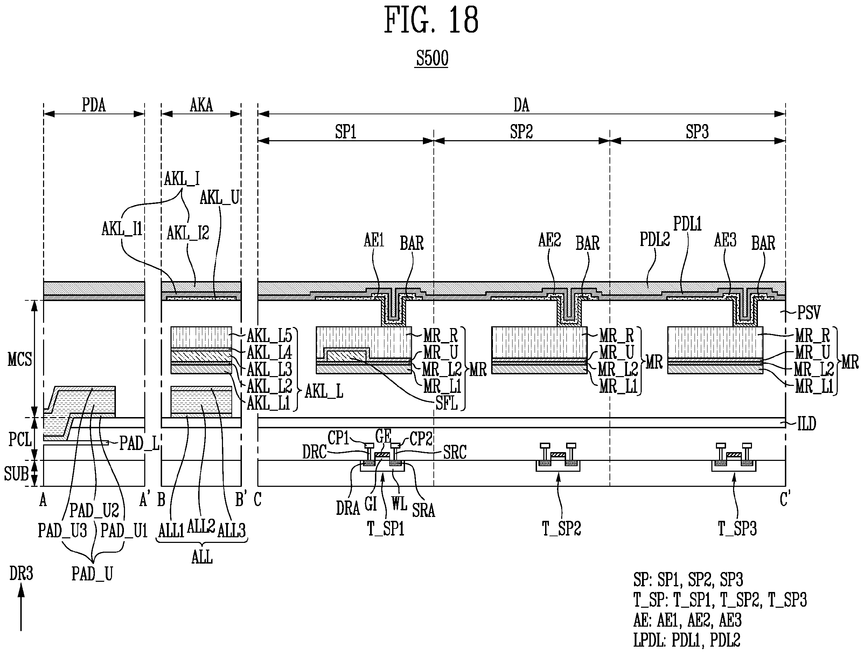

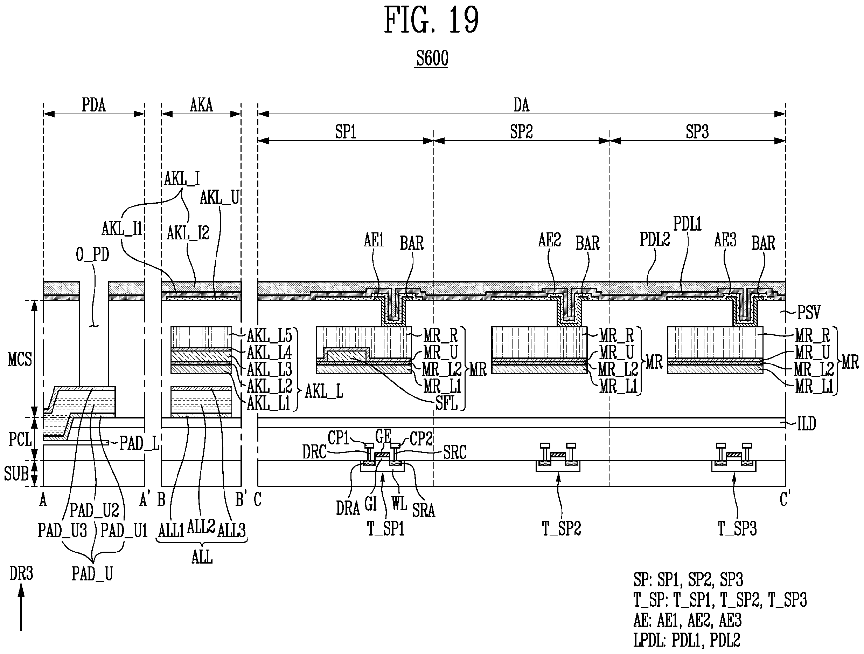

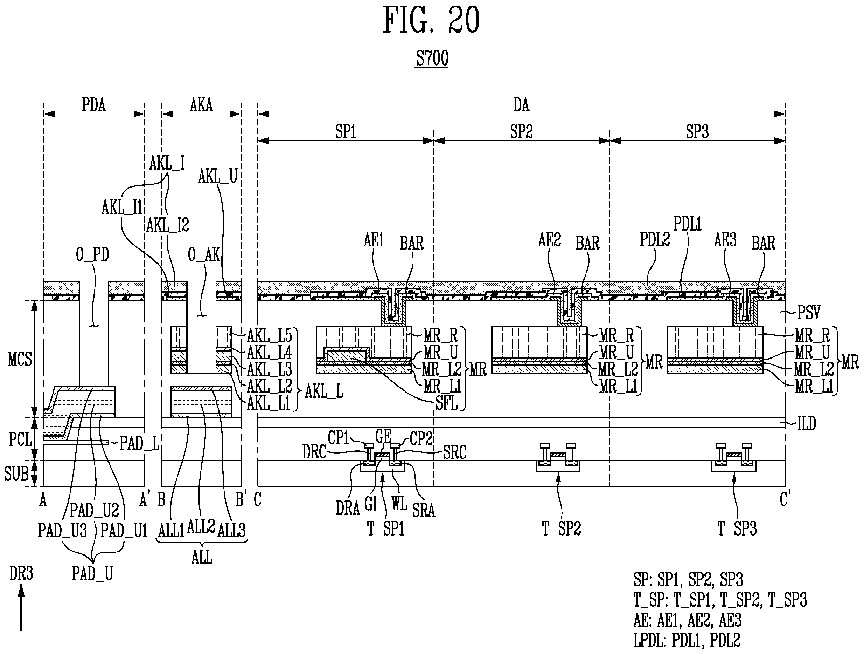

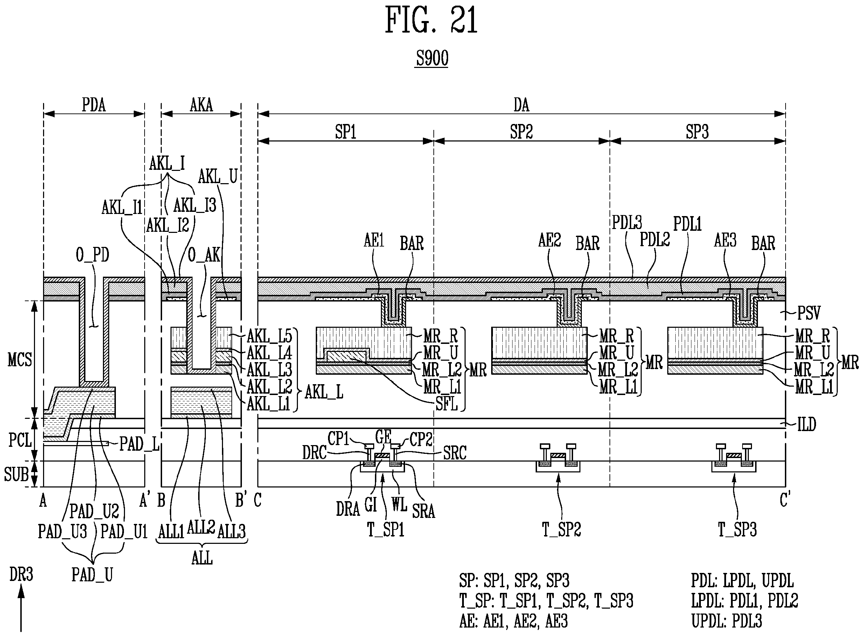

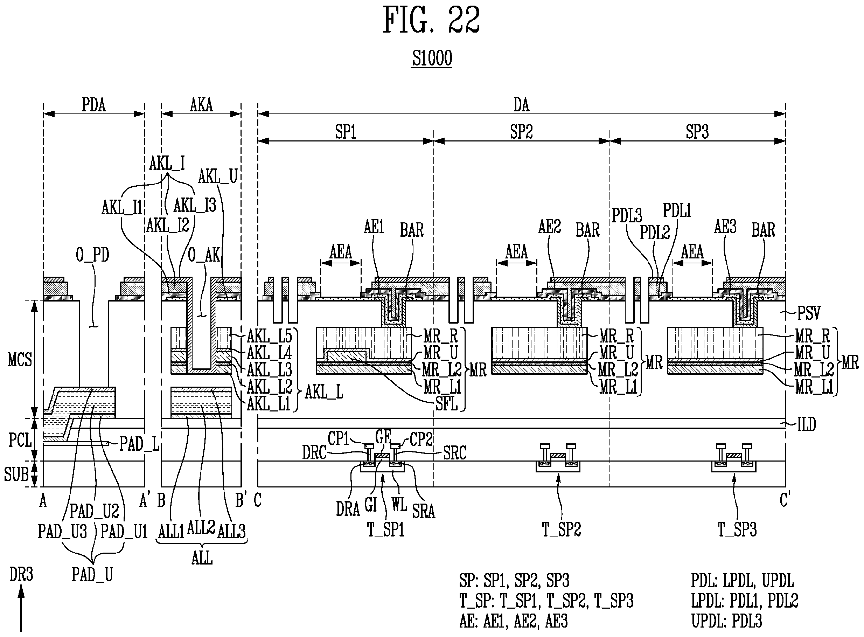

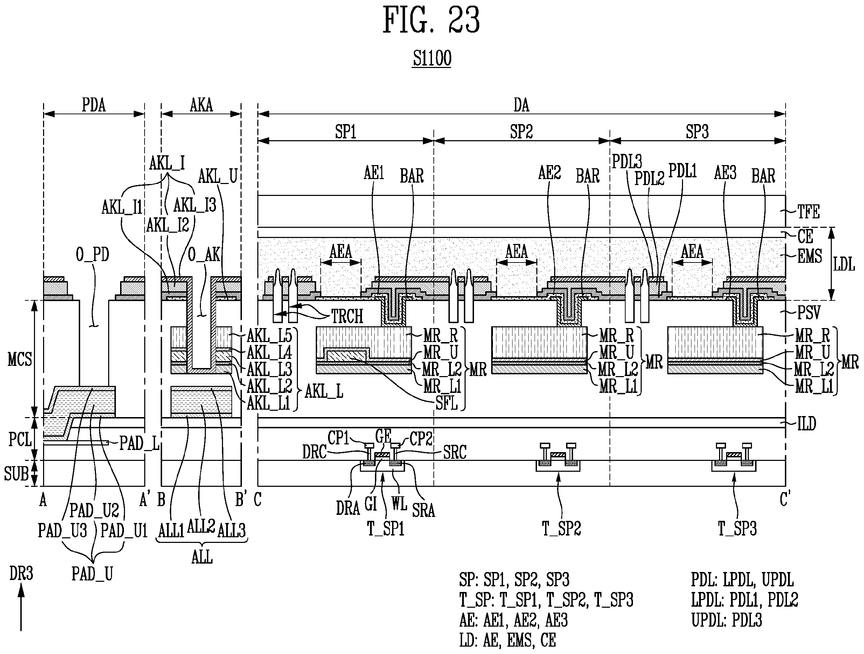

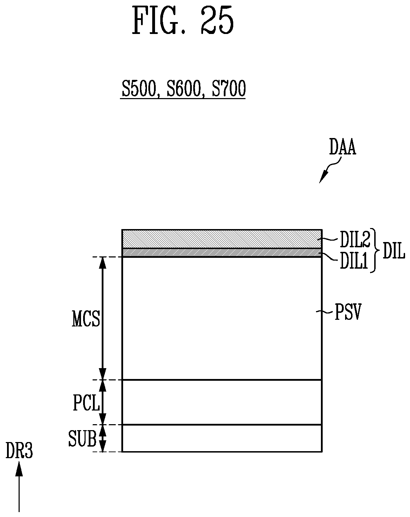

With reference to FIGS. 13 to 35, a method of manufacturing the display device 100 according to some embodiments is described. A content that may overlap the content described above is briefly described or is not repeated.

First, the method of manufacturing the display device 100 according to some embodiments is described with reference to FIGS. 13 to 26.

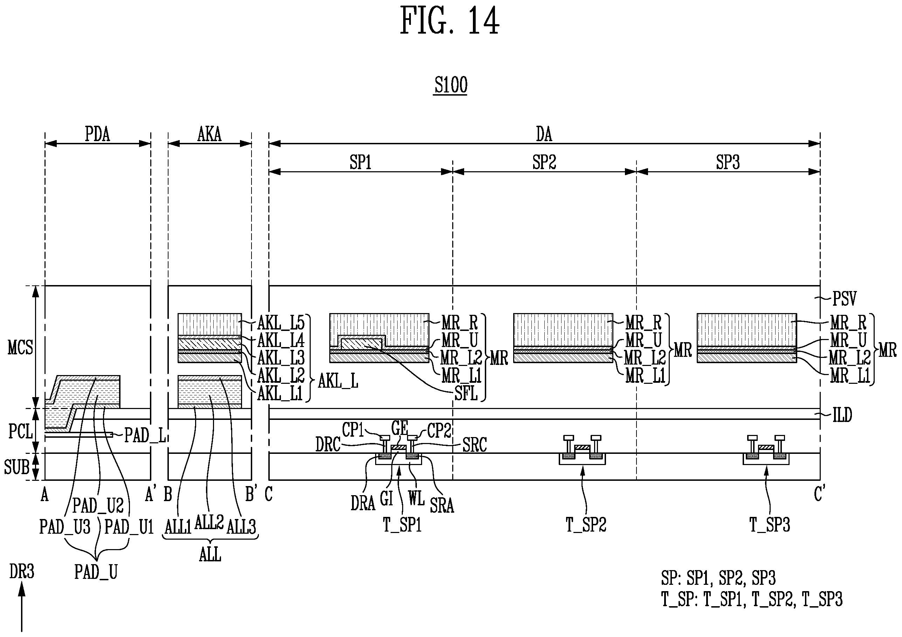

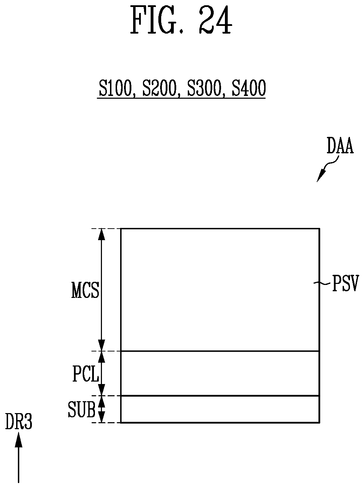

FIG. 13 is a schematic flowchart illustrating aspects of a method of manufacturing the display device according to some embodiments. FIGS. 14 to 26 are schematic cross-sectional views for each process step illustrating the method of manufacturing the display device according to some embodiments. FIGS. 13 to 26 illustrate the method of manufacturing the display device 100 according to some embodiments described above with reference to FIGS. 7 to 10. FIGS. 14 to 23 show cross-sectional views for each process step of the method of manufacturing the display device 100 according to some embodiments based on the cross-sectional structure shown in FIG. 7. FIGS. 24 to 26 show cross-sectional views for each process step of the method of manufacturing the display device 100 according to some embodiments based on the cross-sectional structure shown in FIG. 8.

Referring to FIG. 13, the method of manufacturing the display device 100 according to some embodiments may include manufacturing a pixel circuit layer and an intermediate conductive structure layer (S100), exposing at least a portion of a reflective layer (S200), patterning a barrier layer (S300), patterning an anode electrode (S400), forming a lower pixel defining layer (S500), exposing at least a portion of a pad layer (S600), exposing at least a portion of an alignment key (S700), forming a dam opening for forming a dam structure (S800), forming an upper pixel defining layer (S900), patterning a pixel defining layer (S1000), and forming a light emitting structure, a cathode electrode, and an encapsulation layer (S1100).

Referring to FIGS. 13, 14, and 24, in manufacturing the pixel circuit layer and the intermediate conductive structure layer (S100), the pixel circuit layer PCL and the intermediate conductive structure layer MCS may be formed on the substrate SUB in the pad area PDA, the alignment key area AKA, the display area DA, and the dam area DAA.

According to some embodiments, a conductive layer and an insulating layer on the substrate SUB may be formed based on a general process for manufacturing a semiconductor device. For example, the conductive layer or the insulating layer on the substrate SUB may be formed by a photolithography process, etched by various methods (wet etching, dry etching, and the like), and deposited by various methods (sputtering, chemical vapor deposition, and the like). Embodiments according to the present disclosure are not necessarily limited to a specific example.

In the present step S100, the transistors T_SP, the lower pad layer PAD_L, and the interlayer insulating layer ILD may be formed on the substrate SUB. In addition, the upper pad layer PAD_U and the base alignment key ALL may be formed on the interlayer insulating layer ILD.

In the present step S100, the reflective layers MR corresponding to each of the first to third sub-pixels SP1 to SP3 and the lower alignment key AKL_L may be formed in the display area DA and the alignment key area AKA, respectively.

In the present step S100, the protective layer PSV may be formed, and a step formed by different configurations of the intermediate conductive structure layer MCS may be offset.

Referring to FIGS. 13, 15, and 24, in exposing at least a portion of the reflective layer (S200), a reflective opening OPA exposing at least a portion of the reflective layers MR in the display area DA may be formed.

In the present step S200, at least a portion of the protective layer PSV may be removed to form the reflective opening OPA, and an upper surface of the reflective layer MR (for example, the upper reflective layer MR_R) may be exposed in the reflective opening OPA. The reflective opening OPA may correspond to an area where the barrier layer BAR is located. According to some embodiments, a position of the reflective opening OPA may not overlap the step forming layer SFL in a plan view.

In the present step S200, the lower pad layer PAD_L and the lower alignment key AKL_L may be entirely covered by the protective layer PSV and may not be exposed.

Referring to FIGS. 13, 16, and 24, in patterning the barrier layer (S300), the barrier layers BAR corresponding to the respective first to third sub-pixels SP1 to SP3 in the display area DA may be patterned.

In the present step S300, the barrier layer BAR may be located on the protective layer PSV, and at least a portion of the barrier layer BAR may be provided in the reflective opening OPA. Accordingly, the barrier layer BAR may contact the reflective layer MR in the reflective opening OPA and may be electrically connected to the reflective layer MR.

As the present step S300 is performed, the upper surface of the reflective layer MR may not be exposed.

Referring to FIGS. 13, 17, and 24, in patterning the anode electrode (S400), the first to third anode electrodes AE1 to AE3 and the upper alignment key AKL_U may be patterned.

In the present step S400, the first to third anode electrodes AE1 to AE3 having at least a portion located on the barrier layer BAR in the respective first to third sub-pixels SP1 to SP3 may be patterned. For example, at least a portion of the anode electrodes AE may be provided in the reflective opening OPA.

According to some embodiments, the anode electrode AE include oxide, but the anode electrode AE and the reflective layer MR are spaced apart by the barrier layer BAR. Accordingly, reliability of the anode signal supplied to the reflective layer MR may be relatively improved.

In the present step S400, the upper alignment key AKL_U may be patterned in the alignment key area AKA.

Referring to FIGS. 13, 18, and 25, in forming the lower pixel defining layer (S500), the lower pixel defining layer LPDL, a portion of the insulating layers AKL_I, and a portion of the dam insulating layer DIL may be formed, and a planarization process (for example, chemical mechanical polishing (CMP) process) may be performed.

In the present step S500, the lower pixel defining layer LPDL may be formed throughout the display area DA. At least a portion of the first pixel defining layer PDL1 may be located on the barrier layer BAR, and at least a portion of the second pixel defining layer PDL2 may be located in the reflective opening OPA where the barrier layer BAR is located.

In the present step S500, the first and second insulating layers AKL_I1 and AKL_I2 may be formed in the alignment key area AKA. The first and second dam insulating layers DIL1 and DIL2 may be formed in the dam area DAA. In addition, when the lower pixel defining layer LPDL is formed, a plurality of insulating layers may be formed in the pad area PDA.

Referring to FIGS. 13, 19, and 25, in exposing at least a portion of the pad layer (S600), the pad opening O_PD exposing at least a portion of the upper pad layer PAD_U in the pad area PDA may be formed.

In the present step S600, the protective layer PSV and at least a portion of insulating layers on the protective layer PSV may be removed to form the pad opening O_PD, and an upper surface of the upper pad layer PAD_U (for example, the third upper pad layer PAD_U3) may be exposed.

Referring to FIGS. 13, 20, and 25, in exposing at least a portion of the alignment key (S700), the alignment key opening O_AK exposing at least a portion of the lower alignment key AKL_L in the alignment key area AKA may be formed.

In the present step S700, at least a portion of the protective layer PSV, the upper alignment key AKL_U, and the insulating layer AKL_I may be removed to form the alignment key opening O_AK, and a side surface of the lower alignment key AKL_L may be exposed. Accordingly, an alignment key structure forming a conductive structure may be formed in a plan view.

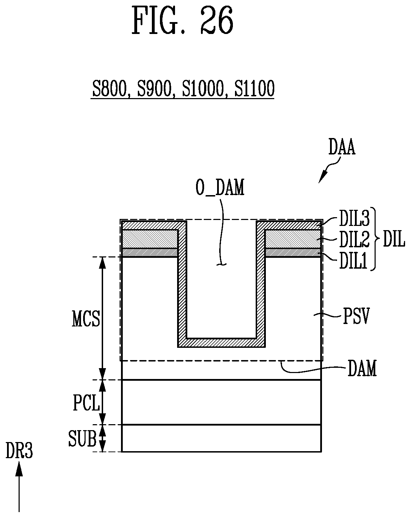

Referring to FIGS. 13 and 26, in forming the dam opening for forming the dam structure (S800), at least a portion of the protective layer PSV may be removed in the dam area DAA and the dam opening O_DAM may be formed.

In the present step S800, as a portion of the protective layer PSV is removed, a portion of the protective layer PSV and the first and second dam insulating layers DIL1 and DIL2 may form a structure protruding in a direction. Accordingly, the dam structure DAM may be formed.

Referring to FIGS. 13, 21, and 26, in forming the upper pixel defining layer (S900), the upper pixel defining layer UPDL, a portion of the insulating layers AKL_I, and a portion of the dam insulating layer DIL may be formed.

In the present step S900, the upper pixel defining layer UPDL may be formed throughout the display area DA. For example, the third pixel defining layer PDL3 may entirely cover the lower pixel defining layer LPDL.

In the present step S900, the third insulating layer AKL_I3 may be formed in the alignment key area AKA, and at least a portion of the third insulating layer AKL_I3 may be provided in the alignment key opening O_AK. In addition, an insulating layer formed in the same process as the third pixel defining layer PDL3 in the pad area PDA may be provided in the pad opening O_PD. In addition, the third dam insulating layer DIL3 may be formed in the dam area DAA, and at least a portion of the third dam insulating layer DIL3 may be provided in the dam opening O_DAM.

Referring to FIGS. 13, 22, and 26, in patterning the pixel defining layer (S1000), at least a portion of each of the lower pixel defining layer LPDL, the upper pixel defining layer UPDL, insulating layers in the pad area PDA, and the dam insulating layers DIL in the dam area DAA may be removed.

In the present step S1000, portions of the pixel defining layer PDL covering the anode electrode AE may be removed, and an upper surface of the anode electrode AE may be exposed in the anode exposure area AEA. The insulating layers in the pad area PDA may be patterned, and thus the upper pad layer PAD_U may be exposed.

Referring to FIGS. 13, 23, and 26, in forming the light emitting structure, the cathode electrode, and the encapsulation layer (S1100), the light emitting structure EMS and the cathode electrode CE may be formed to provide the light emitting element LD, and the encapsulation layer TFE may be formed to passivate the light emitting elements LD.

In the present step S1100, the light emitting structure EMS may be formed, and at least a portion of the light emitting structure EMS may be disconnected or bent between adjacent sub-pixels SP.

According to some embodiments, the additional layers on the encapsulation layer TFE described above with reference to FIG. 2 may be sequentially arranged, and the display device 100 according to some embodiments may be provided.

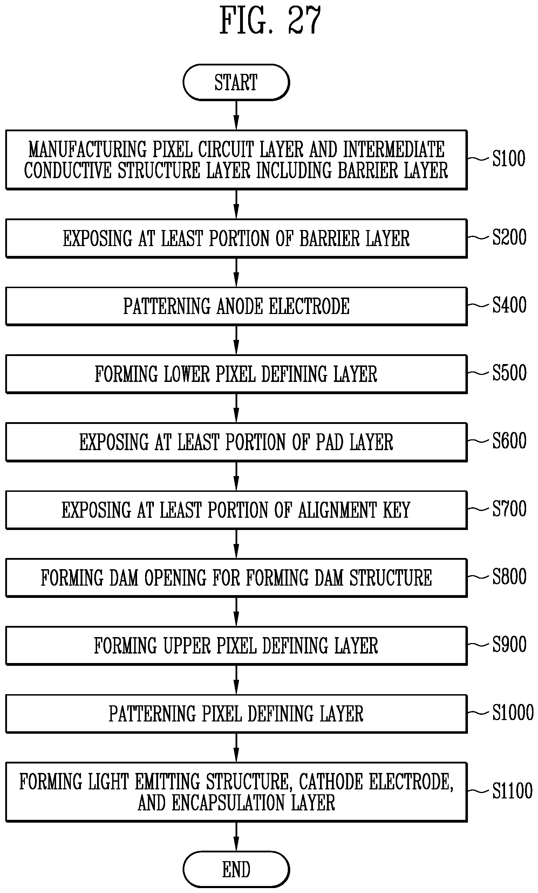

Next, with reference to FIGS. 27 to 30, the method of manufacturing the display device 100 according to some embodiments is described. A content that may overlap the content described above is briefly described or is not repeated.

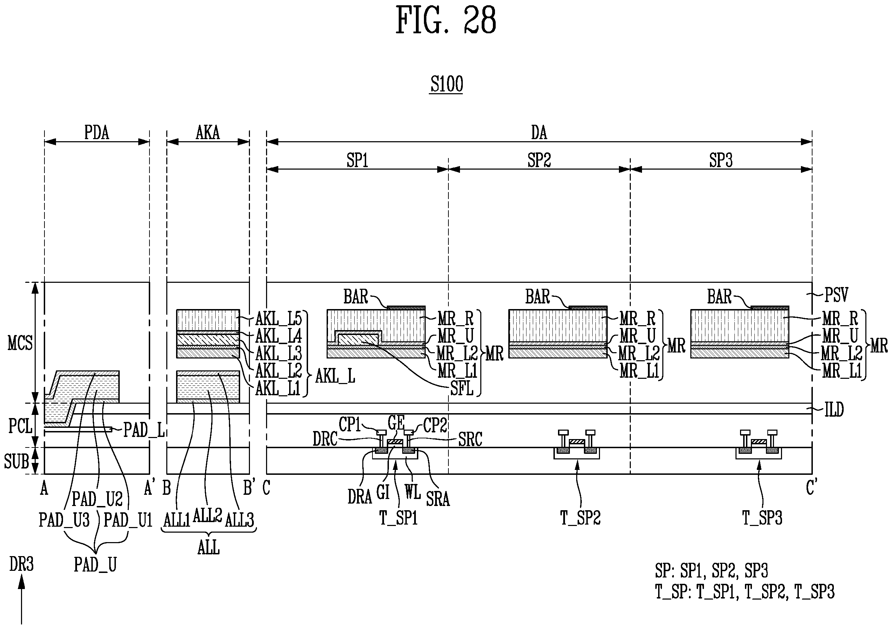

FIG. 27 is a schematic flowchart illustrating the method of manufacturing the display device according to some embodiments. FIGS. 28 to 30 are schematic cross-sectional views for each process step illustrating the method of manufacturing the display device according to some embodiments. FIGS. 28 to 30 illustrate the method of manufacturing the display device 100 according to some embodiments described above with reference to FIG. 11. FIGS. 28 to 30 show cross-sectional views for each process step of the method of manufacturing the display device 100 according to some embodiments based on the cross-sectional structure shown in FIG. 11.

Referring to FIG. 27, the method of manufacturing the display device 100 according to some embodiments may include manufacturing a pixel circuit layer and an intermediate conductive structure layer including a barrier layer (S100), exposing at least a portion of the barrier layer (S200), patterning an anode electrode (S400), forming a lower pixel defining layer (S500), exposing at least a portion of a pad layer (S600), exposing at least a portion of an alignment key (S700), forming a dam opening for forming a dam structure (S800), forming an upper pixel defining layer (S900), patterning a pixel defining layer (S1000), and forming a light emitting structure, a cathode electrode, and an encapsulation layer (S1100).

The method of manufacturing the display device 100 according to the present embodiments is different from the method of manufacturing the display device 100 described above, in that the method of manufacturing the display device 100 according to the present embodiments may not include patterning the barrier layer (S300) and exposing at least a portion of the reflective layer (S200) and may include exposing at least a portion of the barrier layer (S200), and the barrier layer BAR may be manufactured when the intermediate conductive structure layer MCS is manufactured.

Referring to FIGS. 27 and 28, in manufacturing the pixel circuit layer and the intermediate conductive structure layer including the barrier layer (S100), after the barrier layer BAR is patterned on the reflective layer MR, the protective layer PSV may be formed. Accordingly, when the intermediate conductive structure layer MCS is manufactured, the barrier layer BAR may be manufactured.

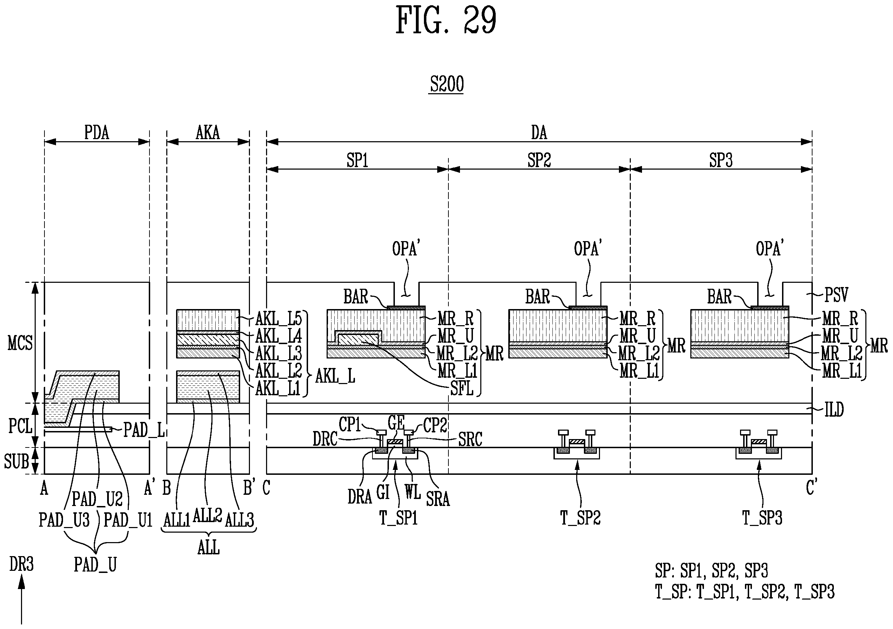

Referring to FIGS. 27 and 29, in exposing at least a portion of the barrier layer (S200), at least a portion of the protective layer PSV may be removed and a barrier opening OPA' exposing an upper surface of the barrier layer BAR may be formed. Similarly to the reflection opening OPA described above, the barrier opening OPA' may be a structure for forming an electrical path through which the anode signal is supplied, and may be an area into which at least a portion of the anode electrode AE enters. According to some embodiments, when the barrier opening OPA' is formed, the reflective layer MR may not be exposed, and thus structural stability of the reflective layer MR may be maintained.

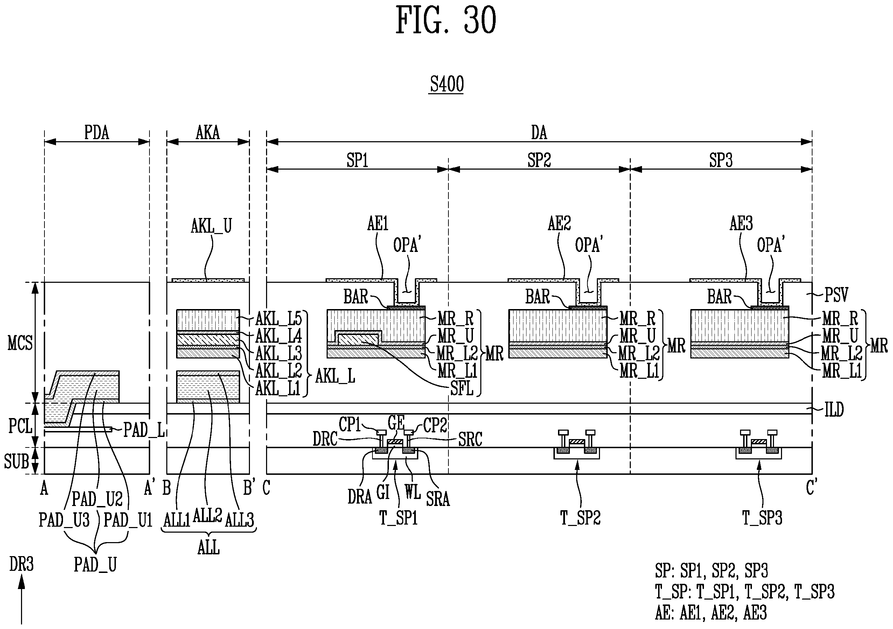

Referring to FIGS. 27 and 30, in patterning the anode electrode (S400), the anode electrodes AE may be patterned, and the anode electrode AE and the barrier layer BAR may be electrically connected. For example, the anode electrode AE may be located (for example, directly located) on a sidewall of the barrier opening OPA'.

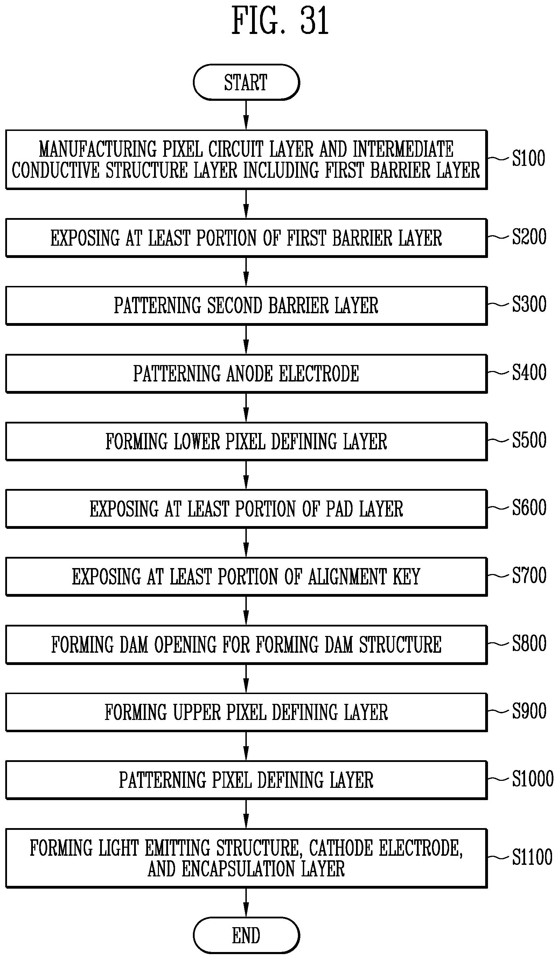

Next, with reference to FIGS. 31 to 35, the method of manufacturing the display device 100 according to some embodiments is described. A content that may overlap the content described above is briefly described or is not repeated.

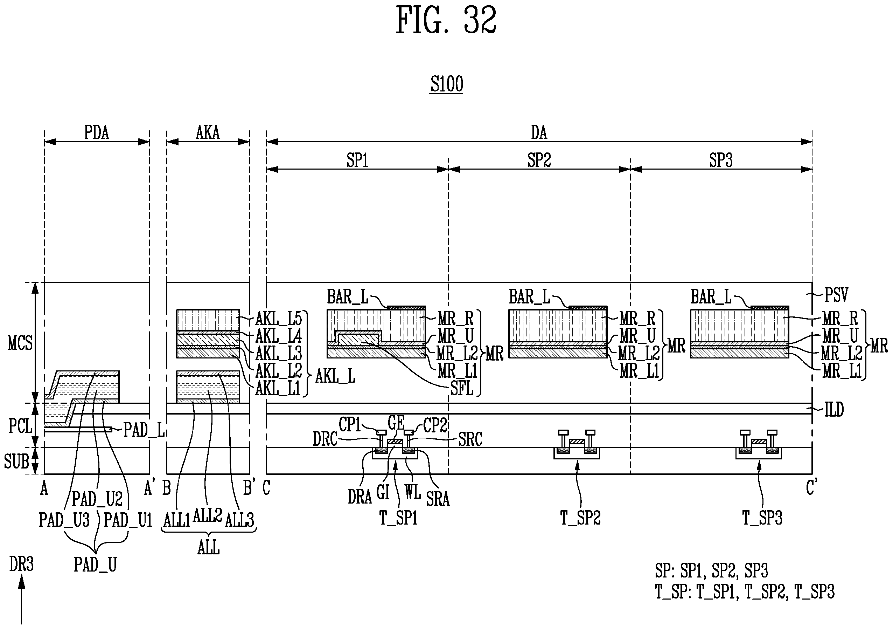

FIG. 31 is a schematic flowchart illustrating the method of manufacturing the display device according to some embodiments. FIGS. 32 to 35 are schematic cross-sectional views for each process step illustrating the method of manufacturing the display device according to some embodiments. FIGS. 32 to 35 illustrate the method of manufacturing the display device 100 according to some embodiments described above with reference to FIG. 12. FIGS. 32 to 35 show cross-sectional views for each process step of the method of manufacturing the display device 100 according to some embodiments based on the cross-sectional structure shown in FIG. 12.

Referring to FIG. 31, the method of manufacturing the display device 100 according to some embodiments may include manufacturing a pixel circuit layer and an intermediate conductive structure layer including a first barrier layer (S100), exposing at least a portion of the first barrier layer (S200), patterning a second barrier layer (S300), patterning an anode electrode (S400), forming a lower pixel defining layer (S500), exposing at least a portion of a pad layer (S600), exposing at least a portion of an alignment key (S700), forming a dam opening for forming a dam structure (S800), forming an upper pixel defining layer (S900), patterning a pixel defining layer (S1000), and forming a light emitting structure, a cathode electrode, and an encapsulation layer (S1100).

The method of manufacturing the display device 100 according to the present embodiments is different from the method of manufacturing the display device 100 described above, in that the method of manufacturing the display device 100 according to the present embodiments may not include exposing at least a portion of the reflective layer (S200) and may include exposing at least a portion of the first barrier layer (S200), the first barrier layer BAR_L is manufactured when the intermediate conductive structure layer MCS is manufactured, and the second barrier layer BAR_U is patterned after the first barrier layer BAR_L is exposed.

Referring to FIGS. 31 and 32, in manufacturing the pixel circuit layer and the intermediate conductive structure layer including the first barrier layer (S100), after the first barrier layer BAR_L is patterned on the reflective layer MR, the protective layer PSV may be formed.

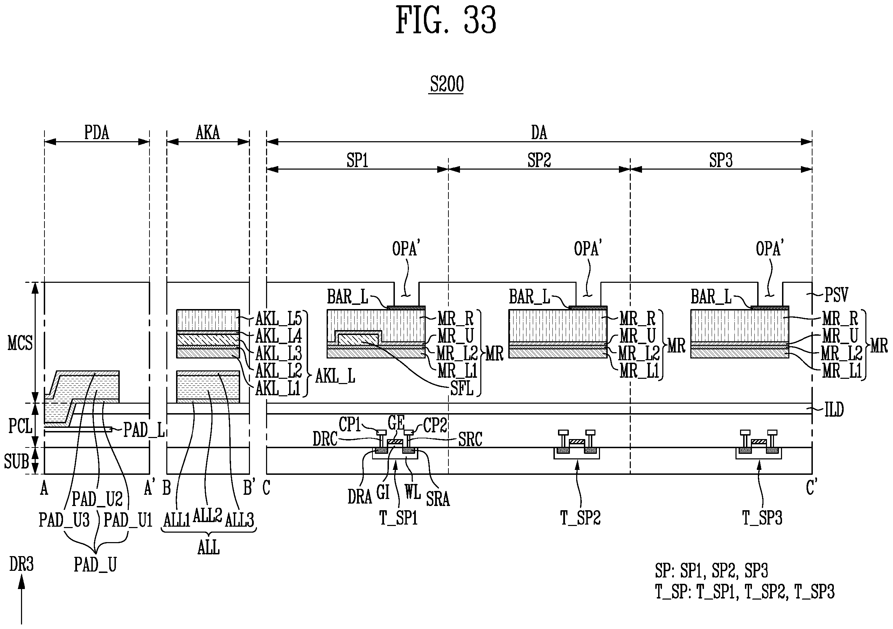

Referring to FIGS. 31 and 33, in exposing at least a portion of the first barrier layer (S200), at least a portion of the protective layer PSV may be removed and an barrier opening OPA' exposing an upper surface of the first barrier layer BAR_L may be formed. According to some embodiments, when the barrier opening OPA' is formed, the reflective layer MR may not be exposed, and thus structural stability of the reflective layer MR may be maintained.

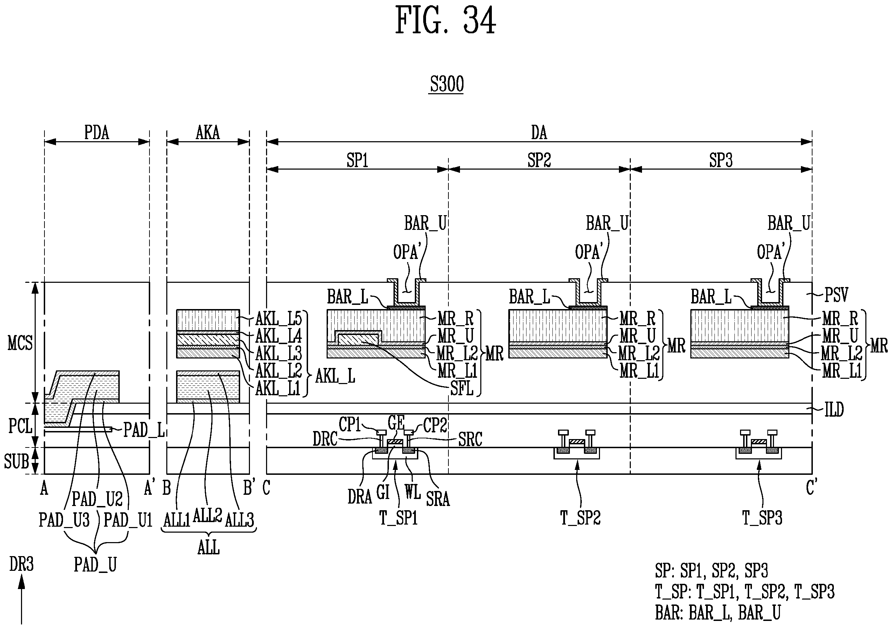

Referring to FIGS. 31 and 34, in patterning the second barrier layer (S300), the second barrier layer BAR_U of which at least a portion is provided in the barrier opening OPA' may be patterned. The second barrier layer BAR_U may be patterned after the protective layer PSV is formed. Accordingly, the barrier layer BAR including the first and second barrier layers BAR_L and BAR_U manufactured in separate processes may be provided.

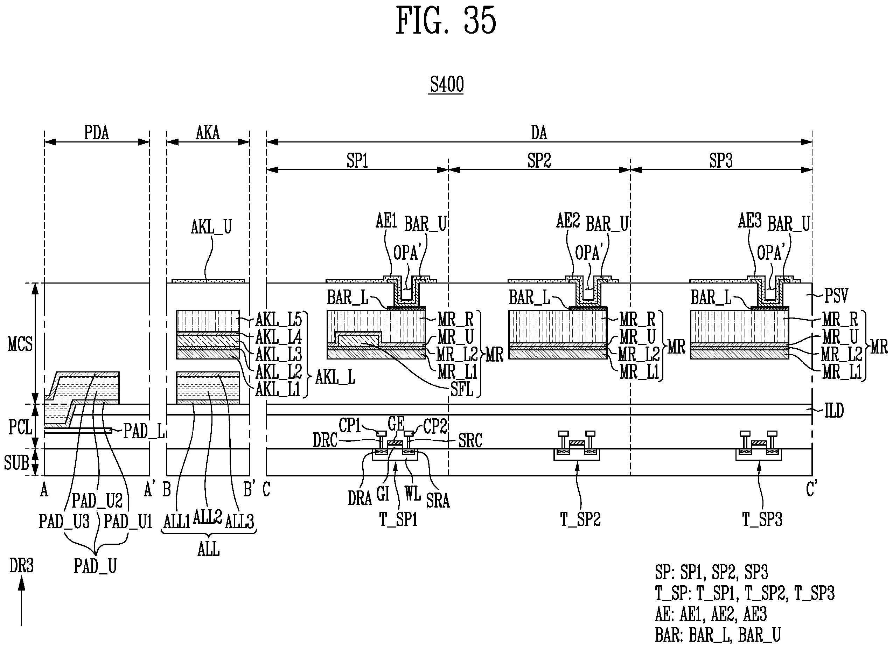

Referring to FIGS. 31 and 35, in patterning the anode electrode (S400), the anode electrodes AE may be patterned, and the anode electrode AE may be electrically connected to the reflective layer MR through the first and second barrier layers BAR_L and BAR_U.

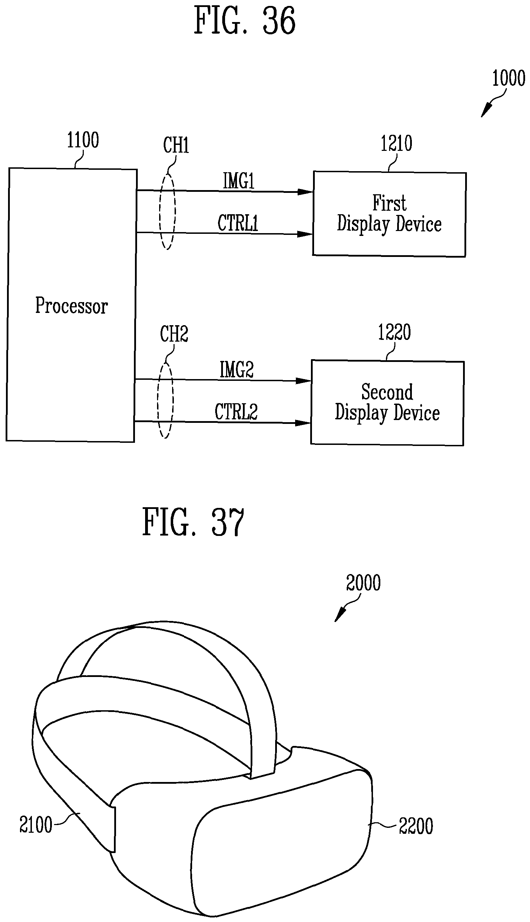

FIG. 36 is a block diagram illustrating aspects of a display system according to some embodiments.

Referring to FIG. 36, the display system 1000 may include a processor 1100 and one or more display devices 1210 and 1220.

The processor 1100 may perform various tasks and calculations. According to some embodiments, the processor 1100 may include an application processor, a graphic processor, a microprocessor, a central processing unit (CPU), and the like. The processor 1100 may be connected to other components of the display system 1000 through a bus system and may control the other components.

In FIG. 36, the display system 1000 includes the first and second display devices 1210 and 1220. The processor 1100 may be connected to the first display device 1210 through a first channel CH1 and may be connected to the second display device 1220 through a second channel CH2.

Through the first channel CH1, the processor 1100 may transmit first image data IMG1 and a first control signal CTRL1 to the first display device 1210. The first display device 1210 may display an image based on the first image data IMG1 and the first control signal CTRL1. The first display device 1210 may be configured similarly to the display device 100 described with reference to FIG. 1.

Through the second channel CH2, the processor 1100 may transmit second image data IMG2 and a second control signal CTRL2 to the second display device 1220. The second display device 1220 may display an image based on the second image data IMG2 and the second control signal CTRL2. The second display device 1220 may be configured similarly to the display device 100 described with reference to FIG. 1.

The display system 1000 may include a computing system providing an image display function, such as a portable computer, a mobile phone, a smart phone, a tablet personal computer (PC), a smart watch, a watch phone, a portable multimedia player (PMP), a navigation device, and an ultra-mobile personal computer (UMPC). In addition, the display system 1000 may include at least one of a head mounted display (HMD) device, a virtual reality (VR) device, a mixed reality (MR) device, and an augmented reality (AR) device.

FIG. 37 is a perspective view illustrating an application example of the display system of FIG. 36.

Referring to FIG. 37, the display system 1000 of FIG. 36 may be applied to a head mounted display device 2000. The head mounted display device 2000 may be a wearable electronic device that may be worn on a user's head.

The head mounted display device 2000 may include a head mount band 2100 and a display device receiving case 2200. The head mount band 2100 may be connected to the display device receiving case 2200. The head mount band 2100 may include a horizontal band and/or a vertical band for fixing the head mounted display device 2000 to the user's head. The horizontal band may be configured to surround a side portion of the user's head, and the vertical band may be configured to surround an upper portion of the user's head. However, embodiments are not limited thereto. For example, the head mount band 2100 may be implemented in a glasses frame form, a helmet form, or the like.

The display device receiving case 2200 may receive the first and second display devices 1210 and 1220 of FIG. 36. The display device receiving case 2200 may further receive the processor 1100 of FIG. 36.

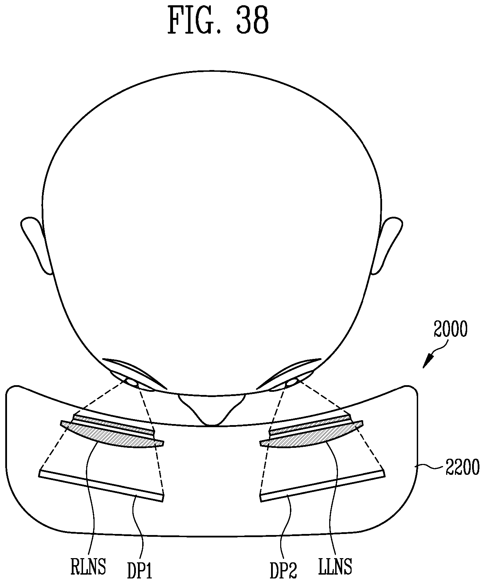

FIG. 38 is a diagram illustrating the head mounted display device of FIG. 37 worn by a user.

Referring to FIG. 38, a first display panel DP1 of the first display device 1210 and a second display panel DP2 of the second display device 1220 are located in the head mounted display device 2000. The head mounted display device 2000 may further include one or more lenses LLNS and RLNS.

Within the display device receiving case 2200, the right eye lens RLNS may be located between the first display device 1210 and a user's right eye. Within the display device receiving case 2200, the left eye lens LLNS may be located between the second display device 1220 and a user's left eye.

An image output from the first display device 1210 may be displayed to the user's right eye through the right eye lens RLNS. The right eye lens RLNS may refract light from the first display device 1210 to be directed toward the user's right eye. The right eye lens RLNS may perform an optical function for adjusting a viewing distance between the first display device 1210 and the user's right eye.

An image output from the second display device 1220 may be displayed to the user's left eye through the left eye lens LLNS. The left eye lens LLNS may refract light from the second display device 1220 to be directed toward the user's left eye. The left eye lens LLNS may perform an optical function for adjusting a viewing distance between the second display device 1220 and the user's left eye.

According to some embodiments, each of the right eye lens RLNS and the left eye lens LLNS may include an optical lens having a pancake-shaped cross-section. According to some embodiments, each of the right eye lens RLNS and the left eye lens LLNS may include a multi-channel lens including sub-areas having different optical characteristics. In this case, each display panel may output images respectively corresponding to the sub-areas of the multi-channel lens, and the output images may pass through the respective corresponding sub-areas and may be viewed to the user.

Although specific embodiments and application examples are described herein, other embodiments and modifications may be derived from the above description. Therefore, the present disclosure is not limited to such embodiments, and extends to the scope of the claims set forth below, and their equivalents.

Embodiments are set out in the following clauses:
Clause 1. A display device comprising:
   a substrate disposed on a plane based on a first direction and a second direction;
   a pixel circuit layer disposed on the substrate and including a pixel circuit;
   a reflective layer disposed on the pixel circuit layer;
   a barrier layer partially disposed on the reflective layer;
   an anode electrode including a portion adjacent to the barrier layer and overlapping the reflective layer in a plan view;
   a light emitting structure electrically connected to the anode electrode; and
   a cathode electrode electrically connected to the light emitting structure,
   wherein the anode electrode includes a transparent conductive material including oxide, and is physically spaced apart from the reflective layer.
Clause 2. The display device according to clause 1, wherein the transparent conductive material includes one or more of a group of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂), and
   the barrier layer includes titanium nitride (TiN).
Clause 3. The display device according to any one of clauses 1 or 2, wherein the display device further includes a protective layer covering the reflective layer,
Clause 4. The display device according to any one of clauses 1 or 2, wherein a lower surface of the barrier layer contacts an upper surface of the reflective layer, and at least a portion of the barrier layer is disposed on the protective layer.
Clause 5. The display device according to any one of clauses 1 to 2, wherein a lower surface of the barrier layer entirely contacts an upper surface of the reflective layer.
Clause 6. The display device according to any one of clauses 1 to 2, wherein the display device further includes a protective layer covering the reflective layer,
   the barrier layer includes a first barrier layer and a second barrier layer on the first barrier layer,
   a lower surface of the first barrier layer entirely contacts an upper surface of the reflective layer, and
   at least a portion of the second barrier layer is disposed on the protective layer.
Clause 7. The display device according to any one of clauses 1 to 6, wherein the reflective layer includes a lower reflective layer, an interlayer lower reflective layer on the lower reflective layer, and an upper reflective layer on the interlayer lower reflective layer, and
   the upper reflective layer includes a metal material and is directly adjacent to the barrier layer.
Clause 8. The display device according to clause 7, further comprising:
   a sub-pixel including a first sub-pixel providing light of a first color, a second sub-pixel providing light of a second color, and a third sub-pixel providing light of a third color,
   wherein in the first sub-pixel, the reflective layer further includes a step forming layer disposed on the lower reflective layer and covered by the interlayer lower reflective layer, and
   the barrier layer does not overlap the step forming layer in a plan view.
Clause 9. The display device according to any one of clauses 1 to 8, wherein the display device further includes a protective layer covering the reflective layer and including an opening exposing the reflective layer,
   the display device further comprises a pixel defining layer covering the anode electrode and including a lower pixel defining layer and an upper pixel defining layer on the lower pixel defining layer,
   the lower pixel defining layer exposes the anode electrode in an anode exposure area,
   at least a portion of the lower pixel defining layer is provided in the opening, and
   the barrier layer overlaps the lower pixel defining layer and the upper pixel defining layer in a plan view.
Clause 10. The display device according to clause 9, further comprising:
   a trench passing through the pixel defining layer and a portion of the protective layer,
   wherein the substrate includes a silicon substrate.
Clause 11. The display device according to any one of clauses 1 to 10, further comprising:
   a display area; and
   a dam structure disposed in a dam area formed around the display area and including a dam insulating layer,
   wherein the display device includes a protective layer covering the reflective layer,
   in the dam area, the protective layer includes a dam opening,
   the dam insulating layer includes a first dam insulating layer, a second dam insulating layer on the first dam insulating layer, and a third dam insulating layer on the second dam insulating layer, and
   at least a portion of the third dam insulating layer is provided in the dam opening.
Clause 12. The display device according to any one of clauses 1 to 11, further comprising:
   an alignment key disposed on the pixel circuit layer and including a lower alignment key and an upper alignment key,
   wherein at least a portion of the lower alignment key includes the same material as the reflective layer, and
   at least a portion of the upper alignment key includes the same material as the anode electrode.
Clause 13. A method of manufacturing a display device, the method comprising:
   manufacturing a pixel circuit layer;
   forming a reflective layer on the pixel circuit layer;
   forming a barrier layer on the reflective layer; and
   patterning an anode electrode to be adjacent to the barrier layer,
   wherein the anode electrode includes a transparent conductive material including oxide and is physically spaced apart from the reflective layer.
Clause 14. The method according to clause 13, wherein the transparent conductive material includes one or more of a group of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂), and
   the barrier layer includes titanium nitride (TiN).
Clause 15. The method according to clause 13 or clause 14, further comprising:
   forming a protective layer covering the reflective layer on the pixel circuit layer,
   wherein patterning comprises forming the anode electrode without exposing an upper surface of the reflective layer by the protective layer and the barrier layer.
Clause 16. The method according to clause 15, wherein forming the barrier layer is performed after forming the protective layer.
Clause 17. The method according to clause 15, wherein forming the barrier layer is performed before forming the protective layer.
Clause 18. The method according to clause 15, wherein forming the barrier layer comprises forming a first barrier layer and forming a second barrier layer,
   forming the first barrier layer is performed before forming the protective layer, and
   forming the second barrier layer is performed after forming the protective layer.
Clause 19. The method according to any one of clauses 15 to 18, further comprising:
   patterning a pixel defining layer including a lower pixel defining layer covering the anode electrode and an upper pixel defining layer on the lower pixel defining layer,
   wherein the protective layer includes an opening overlapping the reflective layer when viewed on a plane,
   at least a portion of the lower pixel defining layer is provided in the opening.
Clause 20. The method according to any one of clauses 13 to 19, further comprising:
   forming a light emitting structure electrically connected to the anode electrode;
   forming a cathode electrode electrically connected to the light emitting structure; and
   forming an encapsulation layer covering the cathode electrode.

## Claims

1. A display device comprising:
a substrate arranged on a plane defined by a first direction and a second direction;
a pixel circuit layer on the substrate and including a pixel circuit;
a reflective layer on the pixel circuit layer;
a barrier layer partially on the reflective layer;
an anode electrode including a portion adjacent to the barrier layer and overlapping the reflective layer in a plan view;
a light emitting structure electrically connected to the anode electrode; and
a cathode electrode electrically connected to the light emitting structure,
wherein the anode electrode includes a transparent conductive material including oxide, and is physically spaced apart from the reflective layer.

2. The display device according to claim 1, wherein the transparent conductive material includes at least one of indium tin oxide (ITO), indium zinc oxide (IZO), indium gallium zinc oxide (IGZO), antimony zinc oxide (AZO), indium tin zinc oxide (ITZO), zinc oxide (ZnO), and tin oxide (SnO₂), and the barrier layer includes titanium nitride (TiN).

3. The display device according to any one of claims 1 or 2, wherein the display device further includes a protective layer covering the reflective layer, and
a lower surface of the barrier layer contacts an upper surface of the reflective layer, and at least a portion of the barrier layer is on the protective layer..

4. The display device according to any one of claims 1 or 2, wherein a lower surface of the barrier layer entirely contacts an upper surface of the reflective layer.

5. The display device according to any one of claims 1 or 2, wherein the display device further includes a protective layer covering the reflective layer,
the barrier layer includes a first barrier layer and a second barrier layer on the first barrier layer,
a lower surface of the first barrier layer entirely contacts an upper surface of the reflective layer, and
at least a portion of the second barrier layer is on the protective layer.

6. The display device according to any one of claims 1 to 5, wherein the reflective layer includes a lower reflective layer, an interlayer lower reflective layer on the lower reflective layer, and an upper reflective layer on the interlayer lower reflective layer,
the upper reflective layer includes a metal material and is directly adjacent to the barrier layer,
the display device further comprises: a sub-pixel including a first sub-pixel providing light of a first color, a second sub-pixel providing light of a second color, and a third sub-pixel providing light of a third color,
in the first sub-pixel, the reflective layer further includes a step forming layer on the lower reflective layer and covered by the interlayer lower reflective layer, and
the barrier layer does not overlap the step forming layer in the plan view.

7. The display device according to any one of claims 1 to 6, wherein the display device further includes a protective layer covering the reflective layer and including an opening exposing the reflective layer,
the display device further comprises a pixel defining layer covering the anode electrode and including a lower pixel defining layer and an upper pixel defining layer on the lower pixel defining layer,
the lower pixel defining layer exposes the anode electrode in an anode exposure area,
at least a portion of the lower pixel defining layer is in the opening,
the barrier layer overlaps the lower pixel defining layer and the upper pixel defining layer in the plan view,
the display device further comprises: a trench passing through the pixel defining layer and a portion of the protective layer, and
wherein the substrate includes a silicon substrate.

8. The display device according to any one of claims 1 to 7, further comprising:
a display area; and
a dam structure in a dam area formed around the display area and including a dam insulating layer,
wherein the display device further includes a protective layer covering the reflective layer,
in the dam area, the protective layer includes a dam opening,
the dam insulating layer includes a first dam insulating layer, a second dam insulating layer on the first dam insulating layer, and a third dam insulating layer on the second dam insulating layer, and
at least a portion of the third dam insulating layer is in the dam opening.

9. The display device according to any one of claims 1 to 8, further comprising:
an alignment key on the pixel circuit layer and including a lower alignment key and an upper alignment key,
wherein at least a portion of the lower alignment key includes a same material as the reflective layer, and
at least a portion of the upper alignment key includes a same material as the anode electrode.

10. A method of manufacturing a display device, the method comprising:
manufacturing a pixel circuit layer;
forming a reflective layer on the pixel circuit layer;
forming a barrier layer on the reflective layer; and
patterning an anode electrode to be adjacent to the barrier layer,
wherein the anode electrode includes a transparent conductive material including oxide and is physically spaced apart from the reflective layer.

11. The method according to claim 10, wherein the transparent conductive material includes at least one of indium tin oxide (ITO), indium zinc oxide (IZO), indium gallium zinc oxide (IGZO), antimony zinc oxide (AZO), indium tin zinc oxide (ITZO), zinc oxide (ZnO), or tin oxide (SnO₂), and
the barrier layer includes titanium nitride (TiN).

12. The method according to claim 10 or claim 11, further comprising:
forming a protective layer covering the reflective layer on the pixel circuit layer,
wherein
patterning comprises forming the anode electrode without exposing an upper surface of the reflective layer by the protective layer and the barrier layer.

13. The method according to claim 12, wherein:
(i) forming the barrier layer is performed after forming the protective layer; or
(ii) forming the barrier layer is performed before forming the protective layer.

14. The method according to claim 12, wherein forming the barrier layer comprises forming a first barrier layer and forming a second barrier layer,
forming the first barrier layer is performed before forming the protective layer, and
forming the second barrier layer is performed after forming the protective layer.

15. The method according to any one of claims 12 to 14, further comprising:
patterning a pixel defining layer including a lower pixel defining layer covering the anode electrode and an upper pixel defining layer on the lower pixel defining layer,
wherein
the protective layer includes an opening overlapping the reflective layer when viewed on a plane,
at least a portion of the lower pixel defining layer is provided in the opening, and
the method further comprises: forming a light emitting structure electrically connected to the anode electrode; forming a cathode electrode electrically connected to the light emitting structure; and forming an encapsulation layer covering the cathode electrode.
